# EUROPEAN PATENT SPECIFICATION

(11) **EP 4 284 148 B1**
(45) Date of publication and mention of the grant of the patent: **19.02.2025**
(21) Application number: 23172050.9
(22) Date of filing: 08.05.2023
(51) Int. Cl.: H10N 10/13, H10N 10/17, H10N 19/00

(54) **MEMS THERMOELECTRIC GENERATOR, MANUFACTURING PROCESS OF THE GENERATOR AND HEATING SYSTEM COMPRISING THE GENERATOR**
THERMOELEKTRISCHER MEMS-GENERATOR, HERSTELLUNGSVERFAHREN DES GENERATORS UND HEIZSYSTEM MIT DEM GENERATOR
GÉNÉRATEUR THERMOÉLECTRIQUE MEMS, PROCÉDÉ DE FABRICATION DU GÉNÉRATEUR ET SYSTÈME DE CHAUFFAGE COMPRENANT LE GÉNÉRATEUR

(30) Priority: 26.05.2022 IT 202200011045
(43) Date of publication of application: 29.11.2023
(73) Proprietor: STMicroelectronics S.r.l., 20864 Agrate Brianza (MB) (IT)
(72) Inventor: FERRARI, Paolo, 21013 GALLARATE (VA) (IT); VILLA, Flavio Francesco, 20159 MILANO (IT); DEL SARTO, Marco, 20900 MONZA (MB) (IT)
(74) Representative: Studio Torta S.p.A.

(56) References cited:
- US-A1- 2011 094 556
- US-A1- 2021 242 387
- TOMITA M ET AL: "10[mu]W/cm2-Class High Power Density Planar Si-Nanowire Thermoelectric Energy Harvester Compatible with CMOS-VLSI Technology", 2018 IEEE SYMPOSIUM ON VLSI TECHNOLOGY, IEEE, 18 June 2018 (2018-06-18), pages 93 - 94, XP033429831, DOI: 10.1109/VLSIT.2018.8510659

## Description

The present invention relates to a MEMS thermoelectric generator. Furthermore, it relates to a manufacturing process of the generator and to a heating system comprising the generator. In particular, the thermoelectric generator is of MEMS type and comprises at least one thermoelectric cell and one thermoplastic layer which extends on the thermoelectric cell; a thermal via extends through the thermoplastic layer and allows the propagation of heat, coming from an (external) thermal source coupleable to the MEMS thermoelectric generator, towards one part of the thermoelectric cell. This allows a thermal drop between opposite ends of one or more thermoelectric elements comprised in the thermoelectric cell to be increased.

As known, the direct conversion of thermal energy into electrical power by Seebeck effect is a promising approach for the collection of energy from heat sources (thermal sources). This is particularly useful in the MEMS ("Micro Electro-Mechanical Systems") field when dealing with small temperature gradients (e.g., smaller than a few tens of °C, for example equal to about 40°C) that, precisely in view of the small dimensions, would not be possible to exploit in any other way (e.g., residual heat from industrial plants, residual heat from car engines, low-temperature thermal sources).

The MEMS thermoelectric generators are MEMS devices for exploiting residual heat, coming from thermal sources, which are used for example in the actuators of heater valves without batteries or in torches (in the latter case, exploiting the temperature difference between the human body temperature and the environmental temperature).

In general, thermoelectric generators use thermoelectric materials capable of generating electrical power from the heat received, providing a potential difference (and therefore a current) from a temperature difference (thermal drop) across the generator.

Typically, thermoelectric materials have a low electrical resistivity (ρ, e.g. lower than about 1 mΩ·cm) and a low thermal conductivity (κ, e.g. lower than about 25 W·m⁻¹·K⁻¹). The low thermal conductivity ensures a high temperature difference between the end of the material being heated and the opposite end of the material, even in case of a thermal source that generates a small amount of heat. Furthermore, the voltage difference generated between these ends of the thermoelectric material is directly proportional to the relative temperature difference. Consequently, the low thermal conductivity ensures high voltage differences even from thermal sources that generate a small amount of heat.

Tellurium-based thermoelectric generators are known which use Tellurium-based materials as thermoelectric materials.

Tellurium compounds, such as Bismuth Telluride (Bi₂Te₃), have good Seebeck coefficients (the Seebeck coefficient of a material, also known as thermal power, thermoelectric power, thermoelectric sensitivity, is a measure of the magnitude of the thermoelectric voltage induced by Seebeck effect in response to a temperature difference across this material), high electrical conductivities and low thermal conductivities (e.g., the thermal conductivity of Bismuth Telluride is about 2 W·m⁻¹·K⁻¹). These properties make Bismuth Telluride suitable for being used to form the "thermoelectrically active elements" of a thermoelectric generator (by "thermoelectrically active elements" or "active elements" it is intended the thermoelectric elements of thermoelectric material that are capable of converting a temperature gradient into an electric potential by Seebeck effect).

A conventional Tellurium-based thermoelectric generator comprises a plurality of N-doped Bismuth Telluride active elements and P-doped Bismuth Telluride active elements interconnected between a pair of opposite ceramic substrates provided with metal (Cu or Au) contact regions and conductive lines that interconnect the N-doped and P-doped Bismuth Telluride active elements to each other. The active elements are formed as discrete elements, typically by a process that provides for forming ingots from powdered material and, subsequently, dicing the ingots to form pellets, that define the active elements when inserted between the two ceramic substrates (e.g., in a manual or semi-automatic assembly step) .

Conventional Tellurium-based thermoelectric generators are therefore discrete components and thus bulky and non-scalable. More in detail, Bismuth Telluride is not suitable for being used as a material in standard manufacturing processes of integrated circuits (IC), which instead are based on Silicon; in fact, although solutions which integrate Bismuth Telluride in MEMS devices are known, these solutions are not feasible in the practice on a large scale due to the lack of standardized manufacturing processes in MEMS technology that use Bismuth Telluride. Furthermore, Tellurium is a rather rare element, expensive and with a strong environmental impact and this intrinsically limits its widespread use.

Silicon-based MEMS thermoelectric generators are also known, wherein materials based on Silicon (N-doped and P-doped so that it exhibits Seebeck coefficients different from each other) are used as thermoelectric materials to form the active elements. US 2021/0242387 A1 shows an example of a silicon-based MEMS thermoelectric generator.

The silicon-based thermoelectric generators, manufactured with Silicon-compatible MEMS technologies, generally have a heat flow that is orthogonal to the substrate ("out-of-plane" heat flow) and comprise a plurality of thermoelectric cells with N-P-doped active elements which have a main extension direction orthogonal to the substrate and which are arranged in such a way that the thermoelectric cells are thermally in parallel and electrically in series and/or in parallel with each other. This ensures the maintenance of a temperature difference high enough to allow the correct operation of these thermoelectric generators, but at the same time it makes the latter bulky (e.g., the thickness of the active elements along the main extension direction is in the order of tens of µm). Furthermore, the electrical powers generated by these thermoelectric generators are generally in the order of magnitude of hundreds of µW, while some applications require higher electrical powers and for example in the order of magnitude of mW.

The aim of the present invention is to provide a MEMS thermoelectric generator, a manufacturing process of the generator and a heating system comprising the generator, which overcome the drawbacks of the prior art.

According to the present invention, a MEMS thermoelectric generator, a manufacturing process of the generator and a heating system comprising the generator are provided, as defined in the annexed claims.

For a better understanding of the present invention, a preferred embodiment is now described, purely by way of non-limiting example, with reference to the attached drawings, wherein:
- Figure 1 shows a cross-section of an embodiment of a MEMS thermoelectric generator;
- Figure 2 shows a top view with parts removed of a thermoelectric cell of the MEMS thermoelectric generator of Figure 1, according to an embodiment;
- Figure 3 shows a cross-section of the thermoelectric cell of Figure 2;
- Figure 4 shows a further cross-section of the MEMS thermoelectric generator of Figure 1;
- Figures 5A-5H show, in cross-section, respective manufacturing steps of the thermoelectric cell of Figure 2, according to an embodiment;
- Figures 6A-6D show, in cross-section, respective manufacturing steps of the MEMS thermoelectric generator of Figure 1, according to an embodiment;
- Figure 7 shows a cross-section of a different embodiment of the MEMS thermoelectric generator;
- Figure 8 shows a perspective view of the MEMS thermoelectric generator of Figure 7;
- Figures 9 and 10 show cross-sections of respective and further embodiments of the MEMS thermoelectric generator;
- Figures 11A-11B show, in cross-section, respective manufacturing steps of the MEMS thermoelectric generator of Figure 10, according to an embodiment;
- Figure 12 is a schematic view of a heating system comprising the MEMS thermoelectric generator;
- Figure 13 shows a cross-section of a different embodiment of the thermoelectric cell;
- Figure 14 shows a top view with parts removed of the thermoelectric cell of Figure 13.

In particular, the Figures are shown with reference to a triaxial Cartesian system defined by an X axis, a Y axis and a Z axis, orthogonal to each other.

In the following description, elements common to the different embodiments have been indicated with the same reference numbers.

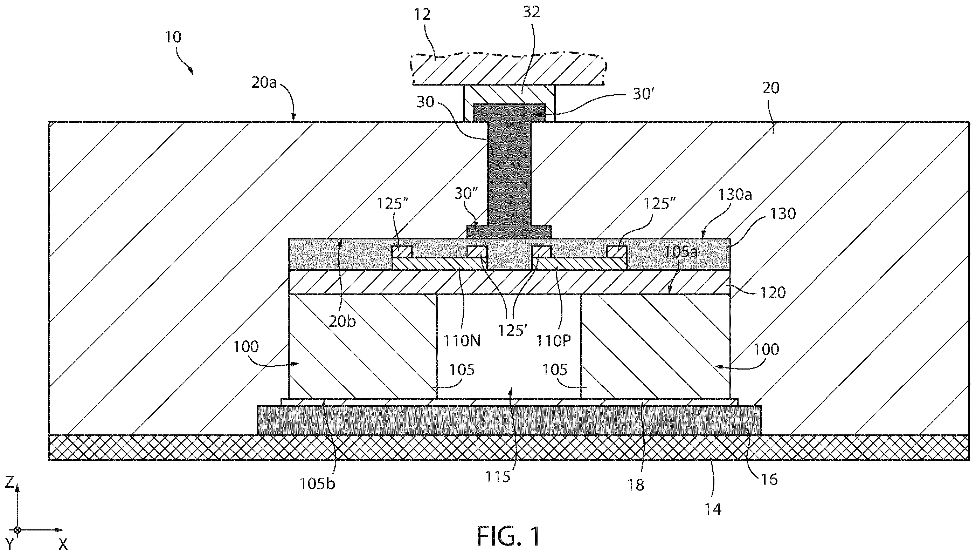

Figure 1 shows an embodiment of a MEMS thermoelectric generator 10 coupleable, in use, to a thermal source 12 so that it exchanges heat with the latter by conduction, in order to generate electrical power from the heat received by the latter. In particular, the MEMS thermoelectric generator 10 is shown in Figure 1 in cross-section in an XZ plane defined by the X and Z axes.

The MEMS thermoelectric generator 10 (more simply also referred to as generator 10 hereinafter) comprises one or more thermoelectric cells 100. Figure 1 shows exemplarily a single thermoelectric cell 100, however it is evident that there may similarly be a plurality of thermoelectric cells 100. In case of more thermoelectric cells 100, they are arranged so that they are thermally in parallel and electrically in series and/or in parallel with each other (the combination of the arrangements in series and parallel occurs for example when there are more groups of thermoelectric cells 100 in parallel with each other, each group comprising thermoelectric cells 100 in series with each other).

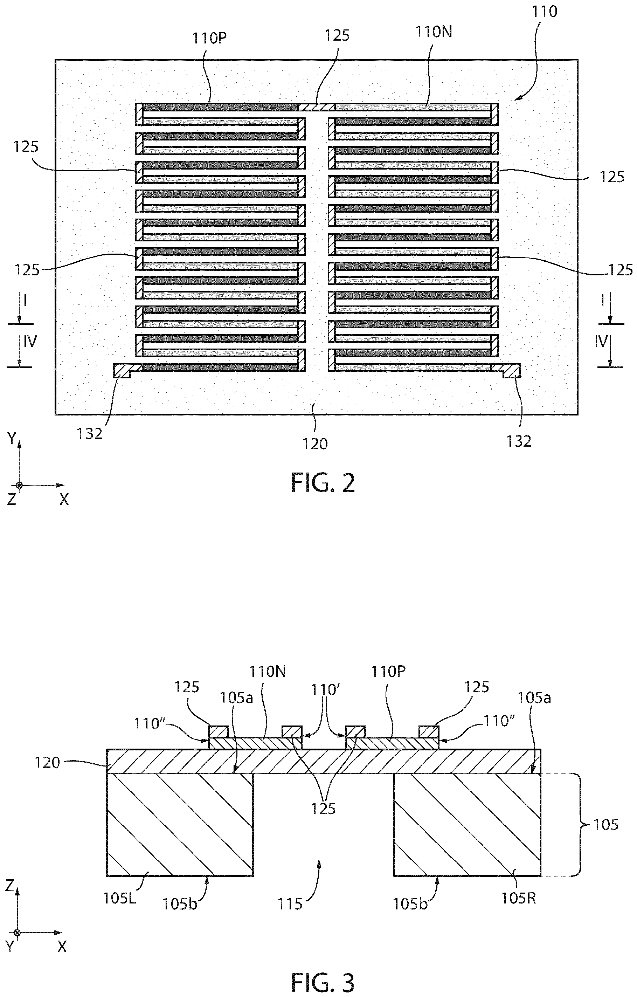

The thermoelectric cell 100 is described in greater detail with reference to Figures 2 and 3 which respectively show a top view (in an XY plane defined by the X and Y axes) and a cross-sectional view (in the XZ plane) of an embodiment of the thermoelectric cell 100. In particular, Figure 3 shows the thermoelectric cell 100 along section line I-I illustrated in Figure 2.

In detail, the thermoelectric cell 100 comprises a substrate 105 of semiconductor material such as silicon. The substrate 105 has a first surface 105a and a second surface 105b opposite to each other along the Z axis.

A cavity 115 extends through the substrate 105, from the first to the second surface 105a, 105b. In the section of Figure 3, the cavity 115 is laterally delimited (i.e. along the X axis) by a first and a second portion 105L and 105R of the substrate 105. In other words, the cavity 115 extends along the X axis between the first and the second portions 105L and 105R.

The thermoelectric cell 100 comprises, on the first surface 105A of the substrate 105, a bottom electrically insulating layer 120, for example of electrically insulating material such as oxide (e.g., silicon oxide). The bottom electrically insulating layer 120 also extends on the cavity 115, so that it is suspended thereon.

The thermoelectric cell 100 further comprises one or more thermoelectric elements 110, configured to convert a thermal drop thereacross into an electric potential by Seebeck effect. The thermoelectric elements 110 are of thermoelectric material, in detail of polysilicon (poly-Si) or polysilicon-germanium (poly-SiGe). The thermoelectric elements 110 extend on the bottom electrically insulating layer 120.

In detail, the thermoelectric elements 110 comprise a plurality of interconnected thermoelectric microstructures. Each thermoelectric microstructure has a main extension direction which is orthogonal to the Z axis and is herein exemplarily considered to be parallel to the X axis. In particular, the thermoelectric microstructures comprise a plurality of thermoelectric microstructures having an N-type conductivity, hereinafter referred to as N-type thermoelectric microstructures 110N, and a plurality of thermoelectric microstructures having a P-type conductivity, hereinafter referred to as P-type thermoelectric microstructures 110P. In greater detail, the N-type thermoelectric microstructures 110N are N-doped (e.g., with phosphorus) poly-Si (or poly-SiGe) thermoelectric microstructures, and the P-type thermoelectric microstructures 110P are P-doped (e.g., with boron) poly-Si (or poly-SiGe) thermoelectric microstructures. In detail, the thermoelectric microstructures 110N,110P exhibit a thermal conductivity comprised between about 5 W·m⁻¹·K⁻¹ and about 25 W·m⁻¹·K⁻¹.

As may be better appreciated in Figure 2, the N-type thermoelectric microstructures 110N and the P-type thermoelectric microstructures 110P are electrically connected in series to each other in an alternated manner through respective electrically conductive elements 125 (e.g., of metal material such as Al, Ag, Au or Cu); in other words, each N-type thermoelectric microstructure 110N is electrically connected in series to a subsequent P-type thermoelectric microstructure 110P through a respective electrically conductive element 125 and to a respective preceding P-type thermoelectric microstructure 110P through a respective and further electrically conductive element 125. In particular, the N-type thermoelectric microstructures 110N and the P-type thermoelectric microstructures 110P are alternated to each other along the Y axis and each of them has a main extension direction parallel to the X axis. Each thermoelectric microstructure 110N and 110P has a first end 110' and a second end 110" opposite to each other along the respective main extension direction (i.e. opposite to each other along the X axis). Each end 110' and 110" is in electrical contact with a respective electrically conductive element 125; for example, the electrically conductive element 125 extends on the respective first or second end 110', 110". Furthermore, in use, the ends 110' and 110" are at different temperatures so that a temperature difference exists therebetween (in detail, T'>T" with T' being the temperature of the first end 110' and T" being the temperature of the second end 110"). Consequently, the heat flow through the thermoelectric microstructures 110N and 110P is of planar type (i.e. it is orthogonal to the Z axis).

Furthermore, each N-type thermoelectric microstructure 110N and P-type thermoelectric microstructure 110P is in part vertically superimposed (i.e. along the Z axis) on the substrate 105 and in part vertically superimposed on the cavity 115. In detail, the first end 110' of each thermoelectric microstructure 110N, 110P is vertically superimposed on the cavity 115 and the second end 110" of each thermoelectric microstructure 110N, 110P is vertically superimposed on the substrate 105. This ensures the temperature difference between the ends 110' and 110". In fact, inside the cavity 115, air or vacuum is present which have much lower thermal conductivity, such as 500 to 1000 (for example, 700) times lower, than the thermal conductivity of the substrate 115. Consequently, the heat generated by the thermal source 12 and provided to the thermoelectric cell 100 at the first ends 110' (as better described hereinbelow) mainly radiates through the thermoelectric microstructures 110N, 110P (with higher thermal conductivity than the bottom electrically insulating layer 120) and then through the substrate 105 towards the second surface 105b. In other words, the cavity 115 thermally operates as an open circuit which prevents the heat from radiating from the first ends 110' directly to the substrate 105 through the bottom electrically insulating layer 120 (i.e. in a substantially vertical manner along the Z axis and therefore with an out-of-plane heat flow), and instead forces the heat to be transmitted through the entire length of the thermoelectric microstructures 110N, 110P before reaching the substrate 105 (i.e. substantially along the X axis at the thermoelectric microstructures 110N, 110P and the bottom electrically insulating layer 120, and therefore with an in-plane heat flow) .

For example, the N-type thermoelectric microstructures 110N and the P-type thermoelectric microstructures 110P are formed on the bottom electrically insulating layer 120 according to a planar serpentine arrangement: an example of such an arrangement is described in M. Tomita et al. "10µW/cm2-Class High Power Density Planar Si-Nanowire Thermoelectric Energy Harvester Compatible with CMOS-VLSI Technology". In detail, the thermoelectric microstructures 110N and 110P may comprise at least two groups of thermoelectric microstructures, each group comprising N-type thermoelectric microstructures 110N and P-type thermoelectric microstructures 110P serpentine arranged and alternated to each other along the Y axis and the groups being arranged laterally to each other along the X axis to form a single serpentine arrangement and in such a way that the ends facing each other of the thermoelectric microstructures 110N and 110P of different groups are at the same temperature in use (in the example of Figure 2 and 3, the first ends 110' of the thermoelectric microstructures 110N and 110P of the two groups shown face each other).

Since the N-type thermoelectric microstructures 110N and the P-type thermoelectric microstructures 110P have opposite types of electrical conductivity, they also have opposite Seebeck coefficients: when the thermal source 12 is coupled to the thermoelectric cell 100 as better described below, a temperature gradient (thermal drop) is established between the ends 110' and 110" of the thermoelectric microstructures 110N, 110P (in fact, the thermoelectric microstructures 110N, 110P are placed between the thermal source 12 and the substrate 105, which in turn is coupled to a heat sink as better described below), which generates by Seebeck effect a respective electric potential difference (voltage difference or voltage drop) between the ends 110' and 110" of each thermoelectric microstructure 110N, 110P and therefore, in view of the serpentine arrangement, induces a total potential difference between electrically conductive terminals 132 placed at the ends of the serpentine arrangement (the total potential difference being equal to the sum of the potential differences between the ends 110' and 110" of each thermoelectric microstructure 110N, 110P and being due to the flow of charge carriers inside the thermoelectric microstructures 110N, 110P driven by the temperature gradient).

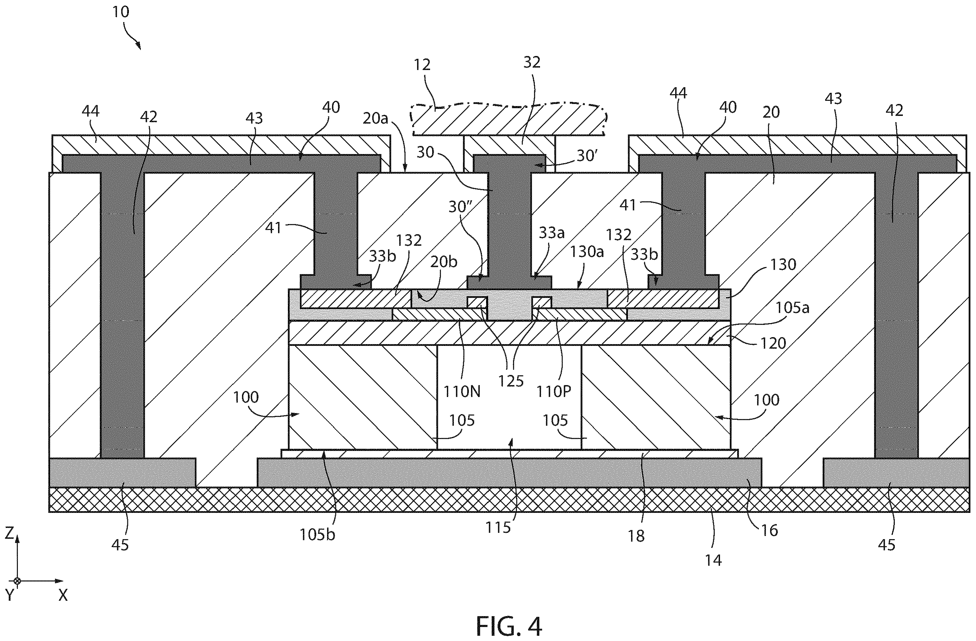

Furthermore, in a manner not shown in Figures 2 and 3 but illustrated in Figure 1, the thermoelectric cell 100 further comprises a top electrically insulating layer 130, for example of insulating material such as oxide (e.g., silicon oxide), which extends on the thermoelectric elements 110 and on the regions of the bottom electrically insulating layer 120 not covered by the thermoelectric elements 110. Furthermore, the top electrically insulating layer 130 extends on the electrically conductive elements 125 in such a way that it covers the electrically conductive elements 125 placed on the first ends 110' of the thermoelectric microstructures 110N, 110P (hereinafter, first electrically conductive elements 125') and the electrically conductive elements 125 placed on the second ends 110" of the thermoelectric microstructures 110N, 110P (hereinafter, second electrically conductive elements 125"), and leaves exposed, at least partially, the electrically conductive terminals 132 (e.g., Figure 4). In this manner the top electrically insulating layer 130 electrically insulates the thermoelectric microstructures 110N, 110P along the serpentine arrangement but also allows its electrical connection towards the external environment through the electrically conductive terminals 132, as better described below.

More generally, the top electrically insulating layer 130 and the bottom electrically insulating layer 120 form an electrically insulating layer 120, 130 wherein the thermoelectric microstructures 110N, 110P and the electrically conductive elements 125 are buried, and which instead at least partially exposes the electrically conductive terminals 132.

With reference again to Figure 1, the generator 10 also comprises a heat sink 14 (e.g., a metal plate of thermally conductive material such as aluminum, optionally including fins that increase heat sinking towards the external environment) thermally coupled to the substrate 105. For example, the second surface 105b of the substrate 105 is fixed to a die pad (of a conductive material such as copper) 16, for example through an adhesive layer 18 (e.g., of "Conductive Die Attach Film", CDAF, type) interposed along the Z axis between the substrate 105 and the die pad 16; furthermore, the die pad 16 is fixed to the heat sink 14 and for example extends on the heat sink 14 so that it is interposed along the Z axis between the latter and the substrate 105. The adhesive layer 18 and the die pad 16 are thermally conductive in such a way that they allow the heat transfer from the substrate 105 to the heat sink 14.

The generator 10 further comprises a total thermoplastic layer configured to be processed (i.e., treated, manipulated) through "Laser Direct Structuring" (LDS) technique, of known type. In the present embodiment, the total thermoplastic layer is formed by a first thermoplastic layer, indicated in Figure 1 with the reference number 20. In particular, the first thermoplastic layer 20 is of thermoplastic polymeric material doped with organic-metal compounds (e.g., chelated complexes of a metal such as palladium, Pd²⁺, or copper, Cu²⁺): when a laser beam radiates the first thermoplastic layer 20, the organic-metal compounds present in the radiated polymeric material are chemically activated in such a way that they become capable of catalyzing the selective precipitation of metal during a subsequent metal deposition step through electroplating, as better described below. Greater details regarding the material of the first thermoplastic layer 20 and the LDS technique may be found in the document "Manufacturing of Molded Interconnect Devices from Prototyping to Mass Production with Laser Direct Structuring", Heininger et al., 2004. Furthermore, the thermoplastic polymeric material is also chosen so that it has a reduced thermal conductivity, in particular lower than about 1 W·m⁻¹·K⁻¹. For example, the thermoplastic polymeric material may be epoxy resin.

The first thermoplastic layer 20 covers the thermoelectric cell 100 so that it thermally insulates it from the thermal source 12. In particular, the first thermoplastic layer 20 extends on the thermoelectric cell 20 (i.e. on a top surface 130a of the top electrically insulating layer 130, opposite to the bottom electrically insulating layer 120 along the Z axis) and also laterally to the thermoelectric cell 20 and on the exposed regions of the die pad 16 and of the heat sink 14 in such a way that the thermoelectric cell 100 is incapsulated between the first thermoplastic layer 20 and the die pad 16. In greater detail, the first thermoplastic layer 20 has a top surface 20a and a bottom surface 20b opposite to each other along the Z axis, where the bottom surface 20b is in contact with the thermoelectric cell 100, the die pad 16 and the heat sink 14.

A thermal via (or thermal connection, or total thermal via), of conductive material such as metal (e.g., copper), extends through the first thermoplastic layer 20 so that it faces (and optionally protrudes beyond) the top surface 20a and is in contact with the thermoelectric cell 100 at the first ends 110' of the thermoelectric microstructures 110N, 110P. In the present embodiment, the thermal via is formed by a first thermal via 30. In detail, the first thermal via 30 extends along the Z axis from the top surface 20a to the bottom surface 20b so that it is in contact with the top surface 130a of the top electrically insulating layer 130 and is vertically superimposed (along the Z axis) on the first electrically conductive elements 125'. The first thermal via 30 has a first end 30' and a second end 30" opposite to each other along the Z axis, the first end 30' protruding outside the first thermoplastic layer 20 at the top surface 20a (or more generally, facing the top surface 20a) and the second end 30" being in contact with the top surface 130a of the top electrically insulating layer 130 and being aligned along the Z axis to the first electrically conductive elements 125'. In detail, the second end 30" extends only on the first ends 110' and on the region comprised therebetween, so that it forces the heat flow to flow through the thermoelectric microstructures 110N, 110P preventing it from occurring in a substantially vertical manner; in greater detail, the first end 110' means the portion of the thermoelectric microstructure 110N, 110P which, along the X axis, has a length equal to at most about 20% of the maximum total length of the thermoelectric microstructure 110N, 110P. Since the top electrically insulating layer 130 is interposed along the Z axis between the first thermal via 30 and the first electrically conductive elements 125', the latter are electrically insulated with respect to the first thermal via 30; however, they exchange heat by conduction with the first thermal via 30, since the top electrically insulating layer 130 is of thermally conductive material (or in any case has a thickness, along the Z axis, such that it creates a reduced thermal resistance, for example lower than about 0.15 Ω).

In particular and as better described below, the first thermal via 30 is provided in the first thermoplastic layer 20 through LDS, i.e. by ablation and activation through laser of portions of the first thermoplastic layer 20, followed by electroplating in the active regions.

For exemplary and non-limiting purposes, the first thermal via 30 has a substantially cylindrical or conical shape (therefore with an XY plane section constant from the first to the second end 30' and 30" or, respectively, decreasing from the first to the second end 30' and 30") or cylindrical/conical shape centrally tapered along the Z axis (as shown in Figure 1, wherein the ends 30' and 30" are joined to each other by a central portion integral with the ends 30' and 30" and with an XY plane section lower than the XY plane sections of the ends 30' and 30"). In particular, the second shape ensures greater areas of contact with the thermal source 12 and with the thermoelectric cell 100 while maintaining the section of the central portion of the first thermal via 30 limited, thus optimizing the heat exchange of the first thermal via 30 without compromising its manufacturability through LDS.

Optionally, a thermal coupling layer 32, of conductive material such as metal (e.g., comprising a stack of metal layers which, in succession to each other, include for example Sn-Cu-Ni-Au), externally surrounds the first end 30' so that it allows the heat exchange between the first thermal via 30 and the external environment (e.g., the thermal source 12) and prevents the oxidation of the first end 30' of the first thermal via 30.

Figure 4 shows the generator 10 along section line IV-IV illustrated in Figure 2, placed at the electrically conductive terminals 132.

As may be seen in Figure 4, each electrically conductive terminal 132 is electrically connected to a respective lead 45 through a respective electrical connection structure 40. The leads 45 and the electrical connection structures 40 are comprised in the generator 10 and are optional. For example, the leads 45 extend on the heat sink 14 (so that they are electrically insulated with respect to the latter, for example through the electrical insulation layer 60 described below), laterally to the die pad 16 and on opposite sides to each other with respect to the die pad 16 along the X axis, so that they are surrounded by the first thermoplastic layer 20 and by the heat sink 14. The leads 45 form, together with the die pad 16, a frame of the generator 10.

In the embodiment of Figure 4, each electrical connection structure 40 comprises a first electrical via 41, a second electrical via 42 and an electrical connection portion 43 which joins the electrical vias 41 and 42. The first and the second electrical vias 41 and 42 are similar to the first thermal via 30 and therefore are not described again in detail. The first electrical via 41 extends through the first thermoplastic layer 20 from the top surface 20a to the thermoelectric cell 100 so that it is in electrical contact with the respective electrically conductive terminal 132. The second electrical via 42 extends through the first thermoplastic layer 20 from the top surface 20a to the respective lead 45 so that it is in electrical contact with the latter. The electrical connection portion 43 is of the same material as the electrical vias 41 and 42 and extends on the top surface 20a between the electrical vias 41 and 42, so that it electrically contacts the latter to each other. Furthermore, an insulation layer 44, of insulating material such as oxide (e.g., insulating tape, with a thickness, along the Z axis, of a few µm), externally surrounds the electrical connection portion 43 so that it electrically and thermally insulate the electrical connection structure 40 with respect to the external environment. In this manner, a conductive path is created between the electrically conductive terminals 132 and the respective leads 45, thus allowing the potential difference generated by the thermoelectric cell 100 to be transferred to the leads 45.

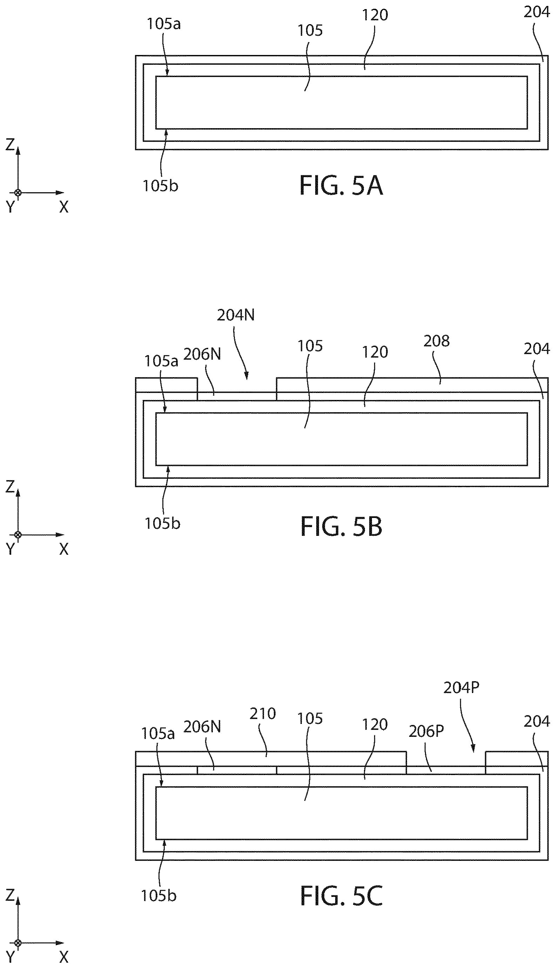

Figures 5A-5H show respective steps of a known manufacturing process of the thermoelectric cell 100 of Figures 2 and 3. In particular, the manufacturing steps are shown with reference to cross-sections of the thermoelectric cell 100 taken along section line I-I.

In Figure 5A, a substrate 105 (i.e. a first wafer of semiconductor material, e.g. Si) is arranged and the bottom electrically insulating layer 120 (of electrically insulating material, such as an oxide, e.g. silicon oxide) and a thermoelectric material layer 204, in detail of polysilicon (poly-Si) or polysilicon-germanium (poly-SiGe) for example of intrinsic type, are formed in succession, on an external surface thereof. In particular, the substrate 105 has a first and a second surface 105a and 105b opposite to each other along the Z axis and forming part of the external surface of the substrate 105. In detail, at the first surface 105a, the bottom electrically insulating layer 120 is formed on the substrate 105 (e.g., by thermal oxidation of the substrate 105) and the thermoelectric material layer 204 is formed on the bottom electrically insulating layer 120 (e.g., by deposition). The thermoelectric material layer 204 is intended to form the thermoelectric elements 110.

In Figure 5B, a first doped portion 206N is provided in the thermoelectric material layer 204, by N-type doping of a first exposed region 204N of the thermoelectric material layer 204. In detail, a first mask 208 is formed on the thermoelectric material layer 204, which covers the thermoelectric material layer 204 so that it leaves the first exposed region 204N exposed; in this first exposed region 204N a selective doping with N-type doping species is performed, in a per se known manner (e.g., by ion implantation); after that, the first mask 208 is removed. The first doped portion 206N is intended to form a respective N-type thermoelectric microstructure 110N.

In Figure 5C, a second doped portion 206P is provided in the thermoelectric material layer 204, laterally to the first doped portion 206N, by P-type doping of a second exposed region 204P of the thermoelectric material layer 204. In detail, a second mask 210 is formed on the thermoelectric material layer 204, which covers the thermoelectric material layer 204 (in particular, the first doped portion 206N) so that it leaves the second exposed region 204P exposed; in this second exposed region 204P a selective doping with P-type doping species is performed, in a per se known manner (e.g., by ion implantation); after that, the second mask 210 is removed. The second doped portion 206P is intended to form a respective P-type thermoelectric microstructure 110P.

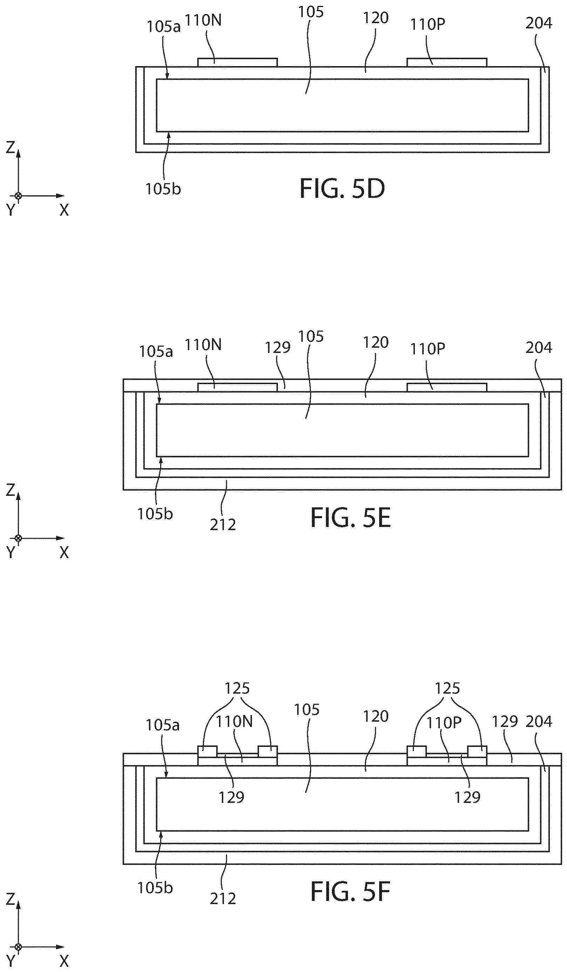

In Figure 5D, the thermoelectric material layer 204 is removed (e.g., by etching, such as dry etching) so that it exposes the bottom electrically insulating layer 120, leaving instead, on the bottom electrically insulating layer 120, the first and the second doped portions 206N and 206P which therefore define respective N- and P-type thermoelectric microstructures 110N, 110P. For example, this etching is performed through a further mask, not shown, which covers the first doped portion 206N and the second doped portion 206P exposing the rest of the thermoelectric material layer 204.

In Figure 5E, a protective oxide layer 212 (optional, of oxide such as silicon oxide) is formed on the thermoelectric material layer 204 and on the N- and P-type thermoelectric microstructures 110N, 110P (e.g., by thermal oxidation of poly-Si or poly-SiGe). Furthermore, a first insulating layer 129 (part of the top electrically insulating layer 130), of insulating material such as BPSG (borophosphosilicate glass), is formed on the thermoelectric material layer 204 and on the N- and P-type thermoelectric microstructures 110N, 110P. For example, this occurs by depositing the insulating material on the thermoelectric material layer 204 and on the N- and P-type thermoelectric microstructures 110N, 110P, followed by reflow of the deposited insulating material.

In Figure 5F, the electrically conductive elements 125 (and similarly the electrically conductive terminals 132, not visible in the Figure which is taken along section line I-I) are provided on the N- and P-type thermoelectric microstructures 110N, 110P. In particular, an etching of the first insulating layer 129 is performed at the ends 110' and 110" of the thermoelectric microstructures 110N, 110P, so that it exposes these ends 110' and 110" (for example, this etching is performed through a further mask not shown which is previously formed on the thermoelectric material layer 204 so that it exposes regions of the latter vertically superimposed, along the Z axis, on the ends 110' and 110"); subsequently, the electrically conductive elements 125 are formed by deposition of metal (e.g., AlCu) at the ends 110' and 110" exposed of the thermoelectric microstructures 110N, 110P, so that the electrically conductive elements 125 are in direct electrical and physical contact with the ends 110' and 110" of the thermoelectric microstructures 110N, 110P.

In a manner not shown, further deposition steps follow, in succession to each other and on the first insulating layer 129 and on the electrically conductive elements 125, of one or more second insulating layers of electrically insulating material such as TEOS and/or of passivating material such as SiN. Together with the first insulating layer 129, these one or more second insulating layers form the top electrically insulating layer 130 which covers the electrically conductive elements 125 and the thermoelectric microstructures 110N, 110P and exposes the electrically conductive terminals 132.

Furthermore, optionally and in a manner not shown, portions of a conductive layer (of metal such as copper, hereinafter referred to as metal contacts) are formed on the top electrically insulating layer 130, laterally to each other along the X axis, intended to form the second ends 30" of the first thermal via 30 and of the first and second electrical vias 41 and 42 and indicated in Figure 4 with the references 33a and 33b. In particular, this occurs removing by etching the portions of the top electrically insulating layer 130 superimposed on the electrically conductive terminals 132, to form respective recesses (not shown) in the top electrically insulating layer 130 which expose the electrically conductive terminals 132 (this step is absent in case the electrically conductive terminals 132 are already exposed by the top electrically insulating layer 130, as for example shown in Figure 4), and subsequently depositing the conductive layer both on the region of the top electrically insulating layer 130 vertically superimposed on the first electrically conductive elements 125', and in the recesses formed in the top electrically insulating layer 130 (or in any case on the first electrically conductive elements 125' exposed by the top electrically insulating layer 130) and optionally also on the regions of the top electrically insulating layer 130 contiguous to the recesses. The portions of the conductive layer (metal contacts) 33a and 33b thus provided are physically and electrically separated from each other. The metal contact 33a superimposed on the first electrically conductive elements 125' forms the second end 30" of the first thermal via 30 and is electrically decoupled from the first electrically conductive elements 125' owing to the top electrically insulating layer 130, while the metal contacts 33b superimposed on the electrically conductive terminals 132 form the second ends 30" of the electrical vias 41 and are electrically coupled to the electrically conductive terminals 132 through the recesses in the top electrically insulating layer 130 (consequently, these metal contacts 33b form conductive vias through the top electrically insulating layer 130).

The steps of Figures 5A-5F lead to form the thermoelectric cell 100, wherein however the substrate 105 does not yet have the cavity 115.

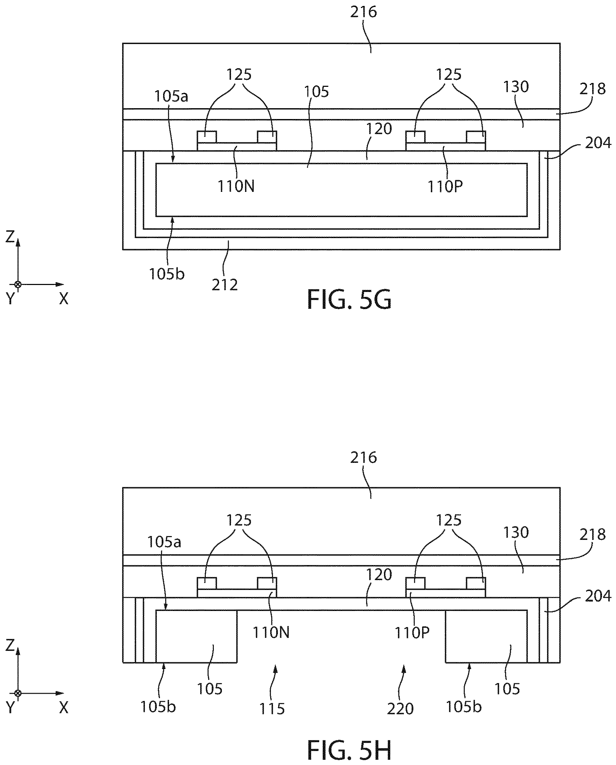

In Figure 5G, a second wafer (or transport wafer) 216 of semiconductor material (e.g., Si) is temporarily coupled (in detail, fixed) to the thermoelectric cell 100 so that it faces the top electrically insulating layer 130. For example, the second wafer 216 is glued to the thermoelectric cell 100 through known wafer bonding techniques, e.g. through a bonding adhesive layer 218 interposed between the second wafer 216 and the top electrically insulating layer 130.

In Figure 5H, the thermoelectric cell 100, supported by the second wafer 216, is subject to polishing (optional) at the second surface 105b of the substrate 105, in order to expose the second surface 105b by removing the bottom electrically insulating layer 120 and the thermoelectric material layer 204 and to reduce the thickness of the substrate 105 along the Z axis. Subsequently, an etching is performed, from the second surface 105b and up to reaching the first surface 105a, to form the cavity 115 in the substrate 105. In particular, a further mask, not shown, is formed on the second surface 105b so that it covers the second surface 105b leaving exposed a relative cavity region 220 wherethrough the etching (e.g., dry etching for example by Bosch etching) is performed which removes the portion of the substrate 105 aligned along the Z axis with the cavity region 220 of the second surface 105b, exposed by the mask, thus forming the cavity 115 which separates the first and the second portions 105L and 105R of the substrate 105 from each other along the X axis. In detail, the cavity region 220 is aligned, along the Z axis, with the first ends 110' of the thermoelectric microstructures 110.

Subsequently, the second wafer 216 and the bonding adhesive layer 218 are removed to obtain the thermoelectric cell of Figure 3.

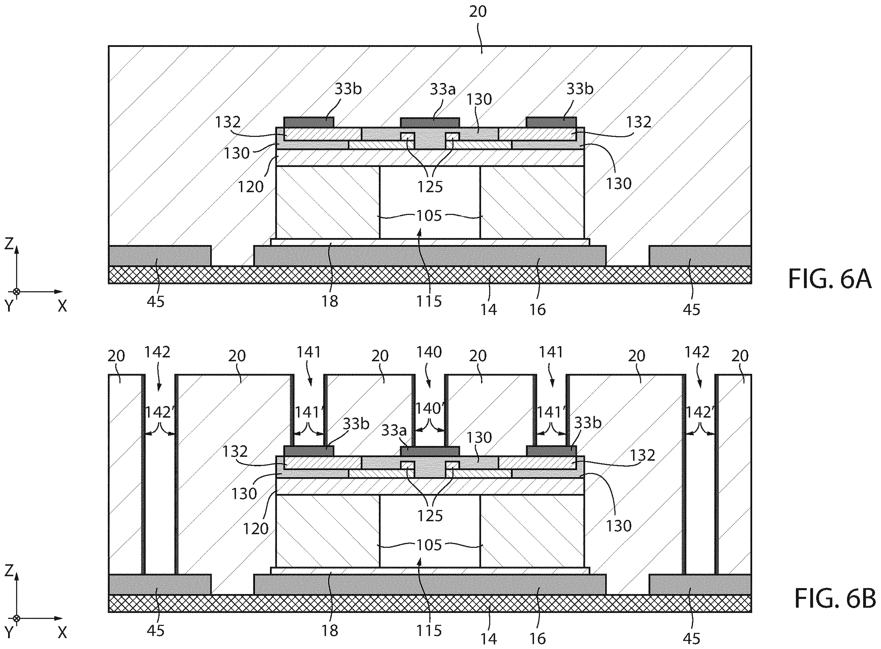

Figures 6A-6D show respective steps of the manufacturing process of the generator 10 of Figures 1 and 4. In particular, the manufacturing steps are shown with reference to cross-sections of the generator 10 taken along section line IV-IV and refer to back-end manufacturing steps of the generator 10.

Figure 6A shows the thermoelectric cell 100 provided according to the steps discussed with reference to Figures 5A-5H. Also shown are the metal contacts 33a and 33b, absent in Figures 5A-5H. With reference to Figure 6A, the thermoelectric cell 100 is fixed to the die pad 16 through the adhesive layer 18. Furthermore, the die pad 16 and the leads 45 are fixed to the heat sink 14, for example through known die attach techniques. Furthermore, the first thermoplastic layer 20 is formed on the thermoelectric cell 100 and on the leads 45. In particular, the first thermoplastic layer 20 is formed by injection molding so that it covers the thermoelectric cell 100, the leads 45 and the heat sink 14 (in detail, so that it extends also between the leads 45 and the thermoelectric cell 100).

In Figure 6B, a first trench 140 vertically superimposed on the metal contact 33a and on the cavity 115, second trenches 141 (optional) vertically superimposed on the respective metal contacts 33b and on the respective electrically conductive terminals 132, and third trenches 142 (optional) vertically superimposed on the respective leads 45 are provided in the first thermoplastic layer 20. Consequently, the trenches 140-142 are arranged laterally to each other and extend from the top surface 20a up to reaching the bottom surface 20b, thus exposing respectively the metal contact 33a, the metal contacts 33b and the leads 45. The trenches 140-142 are provided by LDS technique, i.e. by a laser beam that generates photochemical ablation and vaporization of the radiated polymeric material. In detail, the laser beam impinges on respective trench regions of the top surface 20a of the first thermoplastic layer 20, causing the ablation and the vaporization of the polymeric material in these trench regions and consequently forming the trenches 140-142. The trench regions are therefore vertically superimposed respectively on the metal contact 33a (more generally, on the cavity 115), on the metal contacts 33b and on the leads 45. For example, the laser beam may be generated with a Nd:YAG laser (e.g., with a wavelength λ of about 1064 nm). In addition to the selective removal of the radiated polymeric material, the laser beam also chemically activates the organic-metal compounds comprised in the polymeric material which is radiated without being removed. In greater detail, when the polymeric material is radiated for a longer time than a threshold time (depending in a per se known manner on factors such as the chosen polymeric material and the wavelength of the laser beam), it is vaporized and detaches from the first thermoplastic layer 20; on the other hand, when it is radiated for a shorter time than the threshold time, the polymeric material does not detach from the first thermoplastic layer 20 and the organic-metal compounds comprised therein are chemically modified so that they become selective catalysts of metal precipitation. For this reason, side walls 140', 141', 142' of the trenches 140, 141, 142 are chemically activated by the laser beam during the formation of the trenches 140, 141, 142. Greater details regarding the LDS technique may be found in the document "Manufacturing of Molded Interconnect Devices from Prototyping to Mass Production with Laser Direct Structuring", Heininger et al., 2004.

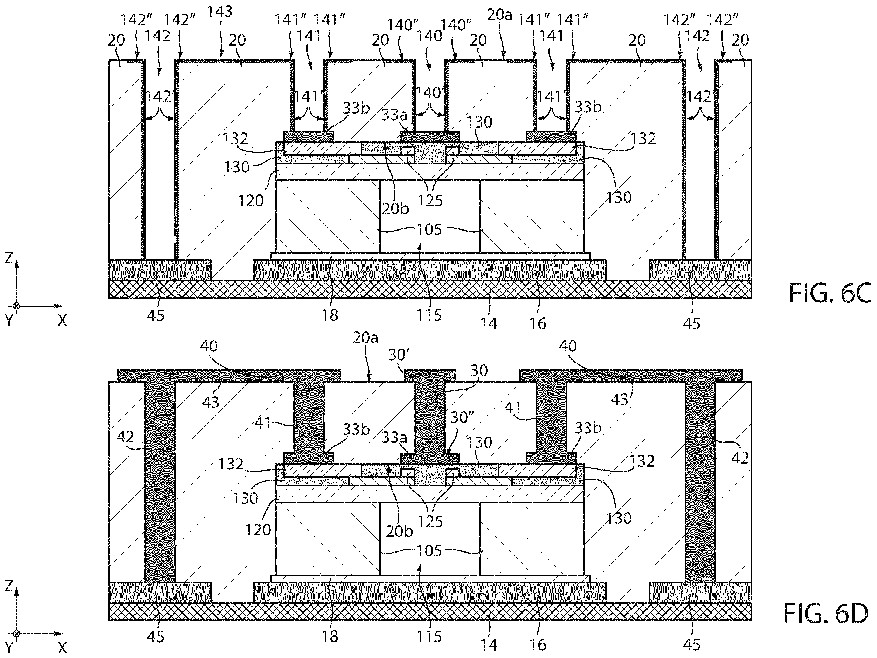

In Figure 6C, some regions of the top surface 20a of the first thermoplastic layer 20, intended to house the first ends 30' of the first thermal via 30 and of the electrical vias 41 and 42 and the electrical connection portions 43, are also optionally chemically activated by radiation with the laser beam. In particular, there are illuminated and activated: a first activated region 140" (optional) of the top surface 20a, which surrounds the opening of the first trench 140 and is intended to house the first end 30' of the first thermal via 30; second activated regions 141" (optional) of the top surface 20a, which surround the openings of the respective second trenches 141 and are intended to house the first ends 30' of the first electrical vias 41; third activated regions 142" (optional) of the top surface 20a, which surround the openings of the respective third trenches 142 and are intended to house the first ends 30' of the second electrical vias 42; fourth activated regions 143 of the top surface 20a, which extend along the X axis between the respective second and third activated regions 142' and 142" (more generally, between the respective second and third trenches 141 and 142) and are intended to house the electrical connection portions 43.

In Figure 6D, a metal deposition step is performed (in detail, by electroplating) to form the vias 30, 41, 42 and the electrical connection portions 43. In particular, metal (e.g., Cu) is deposited in the trenches 140-142 and on the top surface 20a of the first thermoplastic layer 20. The metal deposition adheres to the first thermoplastic layer 20 where the latter has been chemically activated by the laser beam so that it catalyzes the metal precipitation. Consequently, the metal is deposited in the trenches 140-142 (up to reaching and electrically and physically contacting the metal contacts 33a and 33b and the leads 45) and on the activated regions 140"-142", 143. The generator 10 having the first thermal via 30 and the electrical connection structures 40 provided in the first thermoplastic layer 20 therefore defines a molded interconnect device (MID).

Then, in an optional and not-shown manner, the formation of the thermal coupling layer 32 follows on the first end 30' of the first thermal via 30. In particular, this occurs by galvanically growing one or more metal layers (e.g., Sn-Cu-Ni-Au, in succession to each other) on the first end 30' of the first thermal via 30 (of conductive material such as copper).

Furthermore, again in an optional and not-shown manner, the formation of the insulation layer 44 is performed on the electrical connection portions 43. In particular, this occurs by gluing insulating tape on the electrical connection portions 43. With the previously described steps the structure of the generator 10 shown in Figure 4 is obtained.

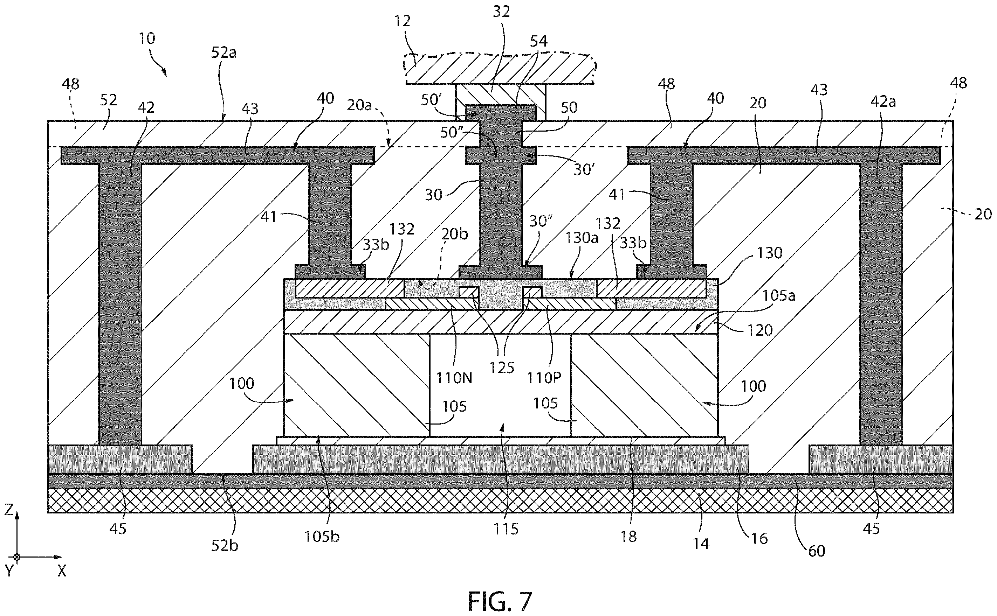

Figure 7 shows a different embodiment of the generator 10. In particular, the generator 10 of Figure 7 is similar to that of Figure 4 and therefore is not described again in detail.

However, in the embodiment of Figure 7 the generator 10 comprises a second thermoplastic layer 48 extending on the first thermoplastic layer 20 previously described and on the electrical connection structures 40. The second thermoplastic layer 48 is similar to the first thermoplastic layer 20 and is integral with the latter. In the present embodiment, the total thermoplastic layer (here indicated with the reference 52) is formed by the first thermoplastic layer 20 and by the second thermoplastic layer 48 and has a top surface 52a (facing, in use, the thermal source 12) and a bottom surface 52b (coinciding with the bottom surface 20b of the first thermoplastic layer 20).

Furthermore, the generator 10 of Figure 7 comprises a second thermal via 50 on the first thermal via 30. In the present embodiment, the thermal via is formed by the first and the second thermal vias 30, 50 and is also indicated with the reference number 54. The second thermal via 50, similar to the first thermal via 30, is vertically superimposed on the first thermal via 30 and is in direct physical contact with the latter. In particular, the first end 30' of the first thermal via 30 functions as the second end 50" of the second thermal via 50, while the first end 50' of the second thermal via 50 faces (optionally protrudes beyond) the top surface 52a. The thermal via 54 traverses the total thermoplastic layer 52 from the top surface 52a (first end 50') up to reaching the top electrically insulating layer 130 of the thermoelectric cell 100 (second end 30"). The thermal source 12 is coupleable to the first end 50' of the second thermal via 50, so that it allows the heat exchange between the thermal source 12 and the thermoelectric cell 100 through the thermal via 54.

In general, in Figure 7 the electrical connection structures 40 are buried in the total thermoplastic layer 52; on the other hand, the first end 50' of the thermal via 54 extends on the top surface 52a in such a way that it may be in contact with the thermal source 12 to receive heat from the latter. In greater detail, the total thermoplastic layer 52 surrounds the electrical connection structures 40 and also extends over the electrical connection portions 43, in particular with a thickness along the Z axis such that it prevents thermal exchange between the electrical connection structures 40 and the external environment. In this manner, the electrical connection structures 40 are thermally insulated with respect to the thermal source 12 by the total thermoplastic layer 52. Consequently, the thermal source 12 may be in contact with the thermal via 54 and the top surface 52a to exchange heat with the thermal via 54, while ensuring the thermal insulation of the electrical connection structures 40. Otherwise, in the embodiment of Figure 4, the thermal and electrical insulation of the electrical connection structures 40 is ensured by the insulation layer 44.

Furthermore, Figure 7 also shows an electrical insulation layer 60 (optional) interposed along the Z axis between the heat sink 14 and the leads 45. Optionally, the electrical insulation layer 60 is also interposed along the Z axis between the heat sink 14 and the die pad 16. The electrical insulation layer 60 fixes the leads 45 and the die pad 16 to the heat sink 14 and is of electrically but not thermally insulating material (e.g., of silicone-based material, such as thermal interface material, TIM). In this manner, the electrical insulation layer 60 allows the heat exchange between the die pad 16 and the heat sink 14 and electrically decouples both the leads 45 and the die pad 16 with respect to the heat sink 14, thus making the operation of the generator 10 independent of any noise or electrical disturbances induced by the external environment on the heat sink 14. Although the electrical insulation layer 60 is shown with reference to the sole embodiment of Figure 7, it may similarly be present in the other embodiments of the generator 10.

The generator 10 of Figure 7 is manufactured using the manufacturing process previously described with reference to Figures 5A-5H and 6A-6D. Furthermore, the manufacturing process according to this embodiment comprises, at the end of the formation of the first thermal via 30 and of the electrical connection structures 40 (Figure 6D, i.e. before the thermal coupling layer 32 and the insulation layer 44 are formed), forming the second thermoplastic layer 48 on the first thermoplastic layer 20 previously formed, on the first thermal via 30 and on the electrical connection structures 40. The formation of the second thermoplastic layer 48 occurs similarly to what has been previously described with reference to Figure 6A and therefore is not described again in detail.

Following the formation of the second thermoplastic layer 48, steps similar to those described with reference to Figures 6B-6D (therefore not described again) follow to form the second thermal via 50 on the first thermal via 30, in such a way that the second thermal via 50 is vertically superimposed on the first thermal via 30 and is in direct physical contact with the latter to form with the latter the thermal via 54 which traverses the total thermoplastic layer 52 from the top surface 52a up to reaching the top electrically insulating layer 130 of the thermoelectric cell 100.

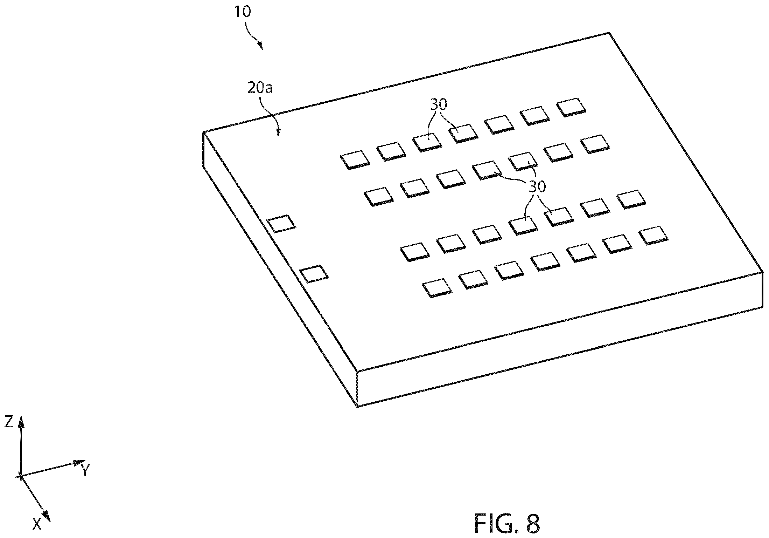

Figure 8 shows an embodiment of the generator 10 wherein the latter comprises a plurality of thermoelectric cells 100 arranged in a matrix parallel to the XY plane. Each thermoelectric cell 100 is connected to the respective first thermal via 30 (or, similarly, to the respective thermal via 54), visible in Figure 5 on the top surface 20a in a respective matrix arrangement (for simplicity of display, Figure 8 does not show the thermal coupling layers 32). As previously described, each thermoelectric cell 100 comprises a respective cavity 115, not shown in Figure 8 as it is internal to the generator 10 and therefore not visible in the perspective view of Figure 8.

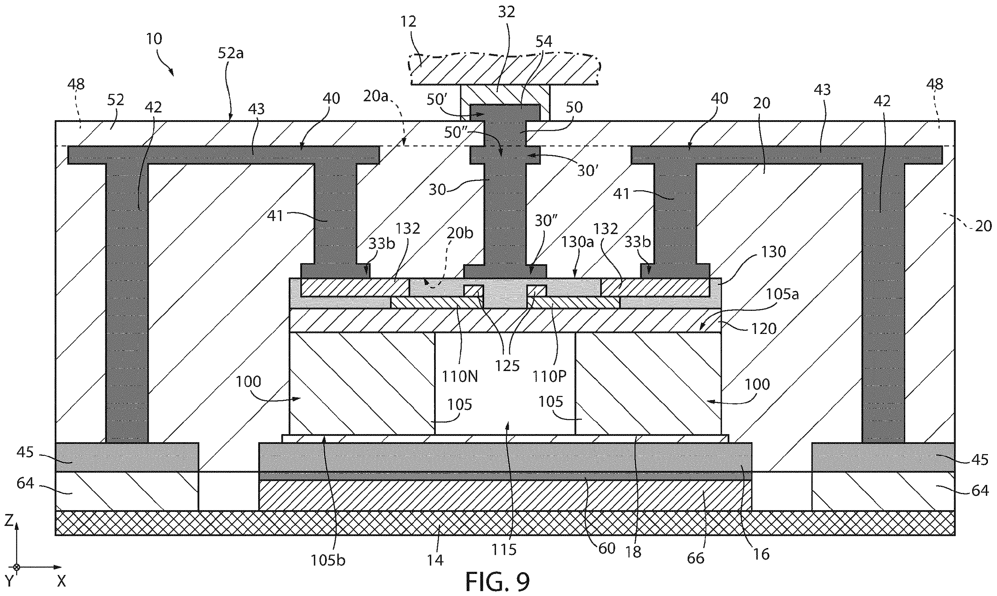

Figure 9 shows a further embodiment of the generator 10. By way of example, the generator 10 of Figure 9 is based on the embodiment of Figure 7; nevertheless, it is evident that the following considerations are similarly applicable also to the other embodiments of the generator 10.

In particular, the generator 10 of Figure 9 has the leads 45 which extend on one (or on respective) PCB(s) ("printed circuit board") 64 which in turn extends on the heat sink 14. Furthermore, optionally, a thermal conduction intermediate element 66 (also called "thermal socket") is present between the heat sink 14 and the die pad 16 (for example, fixed to the latter through the electrical insulation layer 60) to allow the die pad 16 to exchange heat with the heat sink 14. In detail, the thermal conduction intermediate element 66 is of thermally conductive material such as metal, for example aluminum, and has a thickness along the Z axis substantially equal to that of the PCB 64 and in any case such that it allows the die pad 16 to exchange heat with the heat sink 14.

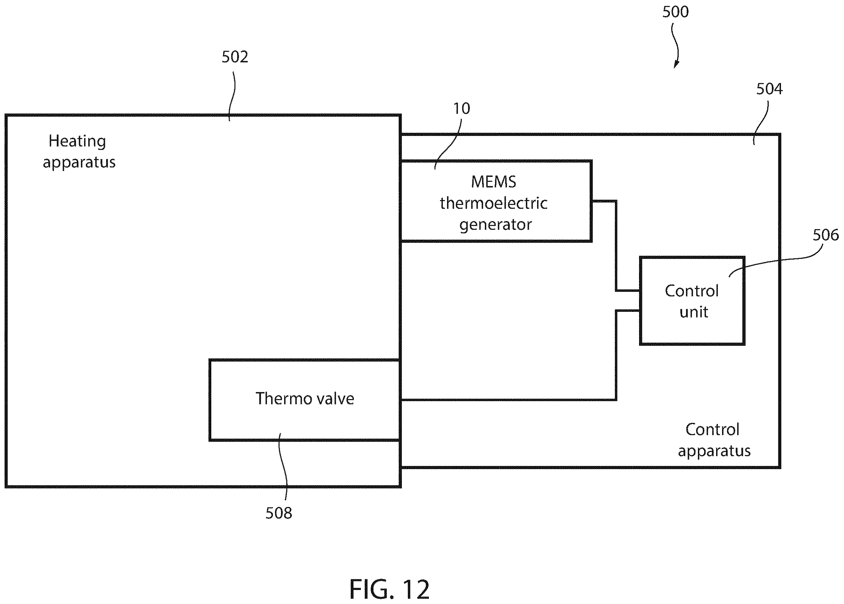

Figure 12 shows an example of application of the generator 10. In particular, Figure 12 shows a heating system 500 comprising a heating apparatus 502 (e.g., a radiator such as a home radiator) and a control apparatus 504. The heating apparatus 502 comprises for example a thermo valve 508 which adjusts the level of heat generated by the heating apparatus 502, in a per se known manner. The control apparatus 504 is coupled to the heating apparatus 502 to receive heat from the latter and for example to control its operation (in detail, to control the thermo valve 508 and thus adjust the level of heat generated by the heating apparatus 502). The control apparatus 504 comprises the generator 10 and, for example, a control unit 506 (e.g., CPU or dedicated microprocessor) electrically coupled to each other. In particular, the generator 10 is coupled to the heating apparatus 502 to receive heat from the latter (which operates as a thermal source 12) and for example to generate an electrical power which powers the control unit 506, in turn coupled to the thermo valve 508 to control its operation. Optionally, the control apparatus 504 may further comprise a battery configured to be recharged by the power supply supplied by the generator 10 and to power the control unit 506 and the thermo valve 508. In this manner, the thermo valve 508 is controlled by the control apparatus 504 which is electrically powered autonomously from the heat generated by the heating apparatus 502, and therefore which does not need to be connected to an external power supply.

From an examination of the characteristics of the invention made according to the present invention, the advantages that it affords are evident.

In detail, the generator 10 is an integrated device which allows the conversion from thermal energy to electrical power. The generator 10 may be made using MEMS technology at low cost and simply, using materials with reduced environmental impact and easy to find.

Furthermore, being an integrated device, the generator 10 occupies a small volume and may generate electrical powers of the order of mW, so it is usable in applications such as the driving of the thermo valves of a radiator.

The generator 10 allows for a heat flow through the thermoelectric microstructures 110N and 110P (of reduced thickness, e.g. equal to a few thousand angstroms, for example up to 1-2 µm) which is of planar type and therefore provides a substantially planar (horizontal) thermoelectric generation structure. This makes the generator 10 more competitive from the industrial point of view (with reduced production cost), simpler from the point of view of manufacture and more mechanically stable.

Furthermore, these high temperature gradients (e.g., temperature differences through the thermoelectric microstructures 110N and 110P of a few tens of °C, e.g. about 40°C) are obtainable in a planar structure owing to the thermal vias 30, 54 (thermally conductive, for example with thermal conductivity equal to hundreds of W·m⁻¹·K⁻¹, e.g. about 400 W·m⁻¹·K⁻¹) immersed in the total thermoplastic layers 20, 52 (thermally insulating, for example with thermal conductivity lower than a few W·m⁻¹·K⁻¹, e.g. about 0.8 W·m⁻¹·K⁻¹) which have a thickness along the Z axis suitably sized to prevent the heat exchange therethrough between the thermal source 12 and the thermoelectric cell 100 in order to guarantee the desired temperature gradient through the thermoelectric microstructures 110N and 110P (e.g., thickness equal to a few µm or tens of µm, e.g. about 10 µm).

Finally, it is clear that modifications and variations may be made to the invention described and illustrated herein without thereby departing from the scope of the present invention, as defined in the attached claims. For example, the different embodiments described may be combined with each other to provide further solutions.

Furthermore, the thermoelectric cell 100 may comprise only one thermoelectric element 110.

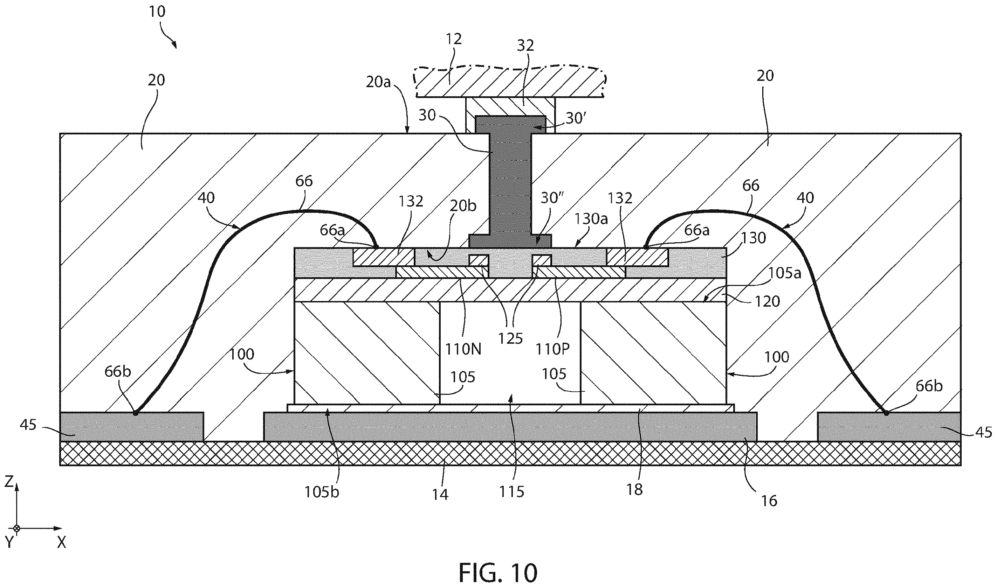

Furthermore, as shown in the embodiment of the generator 10 of Figure 10, the electrical connection structures 40 may each comprise a respective conductive wire 66 of electrically conductive material (e.g., metal such as gold or copper) and having a first end 66a and a second end 66b opposite to each other along a main extension direction of the conductive wire 66. In each conductive wire 66, the first end 66a is coupled to the respective electrically conductive terminal 132 and the second end 66b is coupled to the respective lead 45 so that it electrically connects the electrically conductive terminals 132 to the respective leads 45.

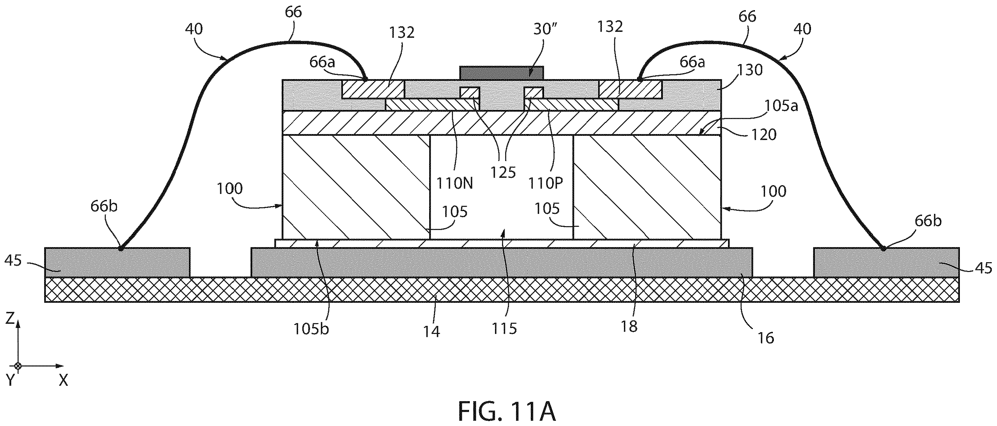

Figures 11A-11B show respective steps of the manufacturing process of the generator 10 of Figure 10.

Initially and in a manner not discussed again, the thermoelectric cell 100 is provided as described with reference to Figures 5A-5H.

Subsequently, with reference to Figure 11A, the thermoelectric cell 100 is fixed to the die pad 16 through the adhesive layer 18. Furthermore, the die pad 16 and the leads 45 are fixed to the heat sink 14, for example by known die attach techniques. Furthermore, the conductive wires 66 are fixed to the respective electrically conductive terminals 132 and to the respective leads 45, by per se known wire bonding techniques.

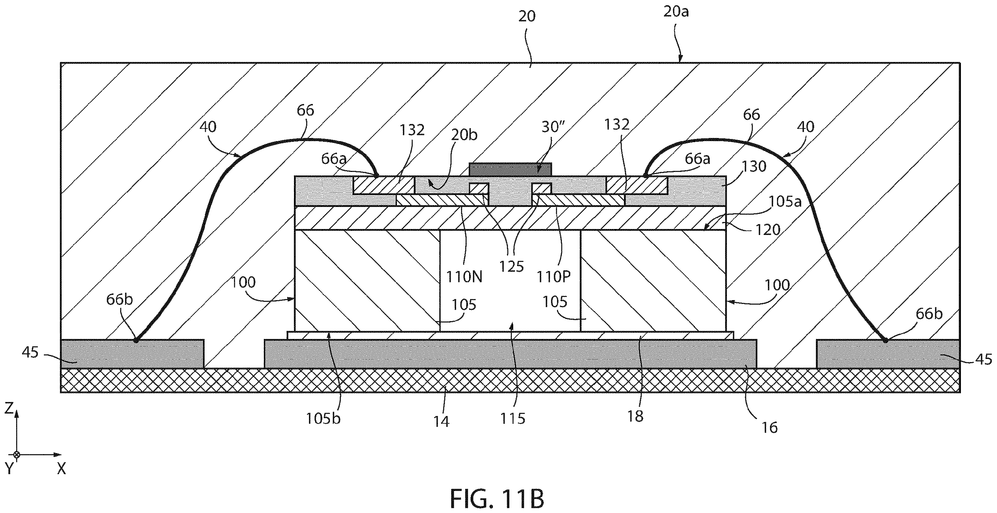

Subsequently, with reference to Figure 11B, the first thermoplastic layer 20 is formed on the thermoelectric cell 100 and on the leads 45 so that it surrounds the conductive wires 66 to thermally insulate them from the external environment. The first thermoplastic layer 20 is formed by injection molding as previously described with reference to Figure 6A.

Then manufacturing steps, similar to those described in Figures 6B-6D, follow to form the first thermal via 30 through the first thermoplastic layer 20, at the end of which the generator of Figure 10 is obtained.

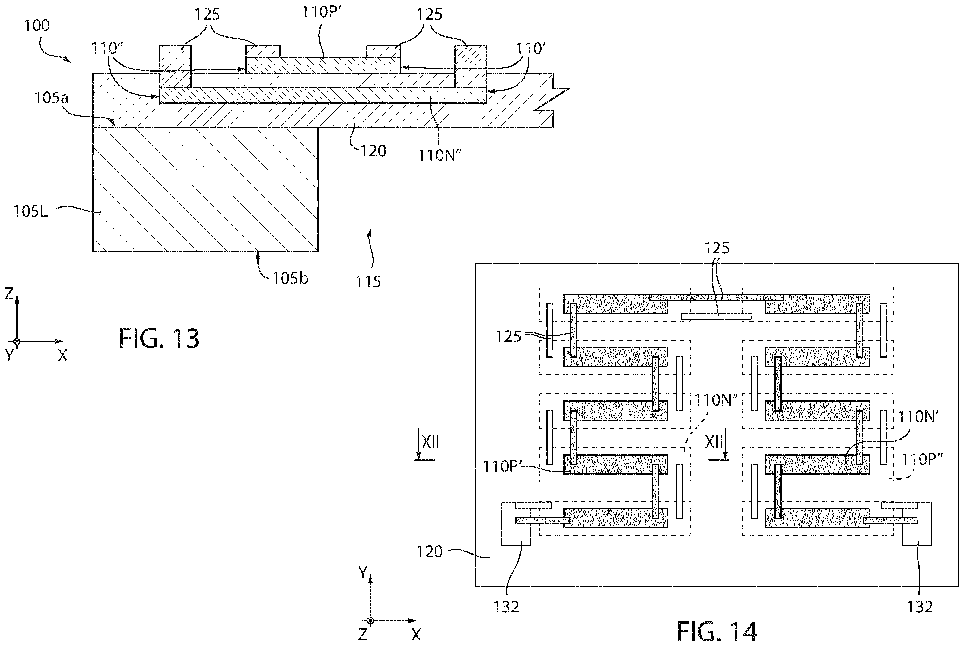

The thermoelectric cell 100 may also comprise thermoelectric elements 110 which are vertically superimposed on each other along the Z axis. In particular, the serpentine arrangement of the thermoelectric microstructures 110N and 110P may be repeated on more levels (i.e. at different heights with respect to the substrate 105) along the Z axis, as shown in Figures 13 and 14. This allows the total potential difference between the electrically conductive terminals 132 to be increased, with the same heat received by the thermal source 12 and surface of the thermoelectric cell in the XY plane.

By way of example, Figures 13 and 14 show the thermoelectric cell 100 with two superimposed levels of thermoelectric microstructures 110N and 110P; however, similar considerations apply to the case of more than two superimposed levels of thermoelectric microstructures 110N and 110P. In detail, Figure 13 shows a portion of the thermoelectric cell 10 corresponding to the part comprising the first portion 105L of the substrate 105 and part of the cavity 115 (in other words, only the left half of the thermoelectric cell 100 is shown, while the right half comprising the second portion 105R of the substrate 105 is not shown for simplicity of description), in a section taken along section line XII-XII shown in Figure 14. On the other hand, Figure 14 is a top view, parallel to the XY plane, of the thermoelectric cell 100 of Figure 13.

As shown in Figure 13, the thermoelectric cell 100 may comprise first thermoelectric microstructures 110N', 110P' extending at a first height with respect to the substrate 105 (e.g., measured along the Z axis with respect to the first surface 105a of the substrate 105) and second thermoelectric microstructures 110N", 110P" extending at a second height with respect to the substrate 105 (e.g., also measured along the Z axis with respect to the first surface 105a of the substrate 105), where the second height is lower than the first height. By way of example, Figure 13 shows a first P-type thermoelectric microstructure 110P' and a second N-type thermoelectric microstructure 110N". In particular, the second N-type thermoelectric microstructure 110N" extends into the bottom electrically insulating layer 120 while the first P-type thermoelectric microstructure 110P' extends on the bottom electrically insulating layer 120 so that it is vertically superimposed on the second N-type thermoelectric microstructure 110N". The electrically conductive elements 125 of the second thermoelectric microstructures 110N", 110P" extend from the respective second thermoelectric microstructures 110N", 110P" up to protruding outside the bottom electrically insulating layer 120, so that it allows the electrical connection of the second thermoelectric microstructures 110N", 110P".

As shown in Figure 14, the first thermoelectric microstructures 110N', 110P' are connected to each other through the electrically conductive elements 125 and have a first serpentine arrangement to each other similarly to what has been discussed with reference to Figure 2; furthermore, the second thermoelectric microstructures 110N", 110P" (shown in dashed line in Figure 14 as they are placed at a different height with respect to that of the first thermoelectric microstructures 110N', 110P') are connected to each other through respective electrically conductive elements 125 and have therebetween a second serpentine arrangement similarly to what has been discussed with reference to Figure 2. The electrically conductive terminals 132 are placed at the ends of both serpentine arrangements. In other words, the first thermoelectric microstructures 110N', 110P' and the second thermoelectric microstructures 110N", 110P" are electrically placed in parallel with each other.

Alternatively, and in a manner not shown, the first thermoelectric microstructures 110N', 110P' and the second thermoelectric microstructures 110N", 110P" are electrically placed in series with each other. This is achieved, for each pair of thermoelectric microstructures superimposed on each other, by electrically contacting, through an electrically conductive element 125, one end of the first thermoelectric microstructure 110N', 110P' with the respective end of the second thermoelectric microstructure 110P", 110N" of opposite electrical conductivity (e.g., the first end 110' of the first P-type thermoelectric microstructure 110P' with the first end 110' of the second N-type thermoelectric microstructure 110N") and electrically contacting, through a further electrically conductive element 125, the other end of the first thermoelectric microstructure 110N', 110P' with the respective other end of the second thermoelectric microstructure 110P", 110N", of opposite electrical conductivity, of the pair of thermoelectric microstructures consecutive, in the serpentine arrangement, to the considered pair (e.g., the second end 100" of the first P-type thermoelectric microstructure 110P' with the second end 110" of the second N-type thermoelectric microstructure 110N" of the consecutive pair).

The thermoelectric cell 100 of Figures 13 and 14 is provided in the following manner. Firstly, the manufacturing steps described with reference to Figures 5A-5D are performed to form the second thermoelectric microstructures 110N", 110P". Subsequently, there are formed a further layer of insulating material such as oxide (e.g., silicon oxide), on the bottom electrically insulating layer 120 and on the second thermoelectric microstructures 110N", 110P", to increase the thickness of the bottom electrically insulating layer 120 and, in succession, a further thermoelectric material layer 204 on the bottom electrically insulating layer 120 of increased type. After that the steps of Figures 5B-5D are repeated to form the first thermoelectric microstructures 110N', 110P' on the bottom electrically insulating layer 120 of increased type. Finally, the steps of Figures 5E-5H are performed to obtain the thermoelectric cell 100 of Figure 14 (in detail, in the step of Figure 5F the electrically conductive elements 125 of both the first thermoelectric microstructures 110N', 110P' and the second thermoelectric microstructures 110N", 110P" are provided).

## Claims

1. A MEMS thermoelectric generator (10) comprising at least one thermoelectric cell (100) including:
- a substrate (105) of semiconductor material, having a first surface (105a) and a second surface (105b) opposite to each other along a first axis (Z), wherein a cavity (115) extends into the substrate (105) along the first axis (Z) from the second surface (105b) up to the first surface (105a);
- an electrically insulating layer (120, 130) of electrically insulating material, extending on the first surface (105a) of the substrate (105) and on the cavity (115);
- one or more thermoelectric elements (110) of thermoelectric material, each thermoelectric element (110) extending into the electrically insulating layer (120, 130), having a first end (110') and a second end (110") opposite to each other along a second axis (X) orthogonal to the first axis (Z) and being configured to convert a thermal drop between the first (110') and the second (110") ends into an electrical potential between the first (110') and the second (110") ends by the Seebeck effect,
wherein the first end (110') of each thermoelectric element (110) is superimposed, along the first axis (Z), on the cavity (115) and the second end (110") of each thermoelectric element (110) is superimposed, along the first axis (Z), on the substrate (105),
the MEMS thermoelectric generator (10) further comprising:
- a total thermoplastic layer (20; 20, 48) extending on the electrically insulating layer (120, 130) and having a top surface (20a; 52a) and a bottom surface (20b) opposite to each other along the first axis (Z), the bottom surface (20b) of the electrically insulating layer (120, 130) facing the electrically insulating layer (120, 130), the total thermoplastic layer (20; 20, 48) being of thermally insulating material and configured to be processed by laser direct structuring, LDS, technique;
- a heat sink (14) coupled to the thermoelectric cell and configured to exchange heat with the thermoelectric cell (100) which extends, along the first axis (Z), between the heat sink (14) and the total thermoplastic layer (20; 20, 48); and
- a thermal via (30; 30, 50) of metal material, extending through the total thermoplastic layer (20; 20, 48) from the top surface (20a; 52a) to the bottom surface (20b) of the total thermoplastic layer (20; 20, 48) so that it is superimposed, along the first axis (Z), on the first end (110') of each thermoelectric element (110),
wherein the MEMS thermoelectric generator (10) is coupleable to a thermal source (12) in such a way that the top surface (20a; 52a) of the total thermoplastic layer (20; 20, 48) faces the thermal source (12) and the thermoelectric cell (100) exchanges heat, through the thermal via (30; 30, 50), with the thermal source (12) to generate the thermal drop between the first (110') and the second (110") ends of each thermoelectric element (110).

2. The MEMS thermoelectric generator according to claim 1, wherein the total thermoplastic layer (20; 20, 48) is of thermoplastic polymeric material doped with organic-metal compounds configured to be chemically activated when radiated by a laser beam.

3. The MEMS thermoelectric generator according to claim 1 or 2, wherein the thermoelectric cell (100) comprises a first plurality of said thermoelectric elements (110),
wherein the first plurality of thermoelectric elements (110) comprises a respective first plurality of thermoelectric microstructures (110N', 110P') which are interconnected through electrically conductive elements (125) to form a first serpentine arrangement,
wherein the first plurality of thermoelectric microstructures (110N', 110P') comprises thermoelectric microstructures (110N'; 110P') having a first type of electrical conductivity and thermoelectric microstructures (110P'; 110N') having a second type of electrical conductivity opposite to the first type, the thermoelectric microstructures (110N'; 110P') with the first type of electrical conductivity and the thermoelectric microstructures (110P'; 110N') with the second type of electrical conductivity being alternated to each other along said first serpentine arrangement, and
wherein the thermoelectric elements (110) and the electrically conductive elements (125) are buried in the electrically insulating layer (120, 130).

4. The MEMS thermoelectric generator according to claim 3, wherein the thermoelectric cell (100) further comprises a second plurality of said thermoelectric elements (110),
wherein the second plurality of thermoelectric elements (110) comprises a respective second plurality of thermoelectric microstructures (110N", 110P") which are interconnected through respective electrically conductive elements (125) to form a second serpentine arrangement,
wherein the second plurality of thermoelectric microstructures (110N", 110P") comprises respective thermoelectric microstructures (110N"; 110P") having the first type of electrical conductivity and respective thermoelectric microstructures (110P"; 110N") having the second type of electrical conductivity, the thermoelectric microstructures (110N"; 110P") with the first type of electrical conductivity and the thermoelectric microstructures (110P"; 110N") with the second type of electrical conductivity being alternated to each other along said second serpentine arrangement,
wherein the first plurality of thermoelectric microstructures (110N', 110P') is superimposed, along the first axis (Z), on the second plurality of thermoelectric microstructures (110N", 110P"), and
wherein the thermoelectric microstructures (110N', 110P') of the first plurality and the second plurality are electrically arranged to each other: in series, the first and the second serpentine arrangements coinciding; or in parallel.

5. The MEMS thermoelectric generator according to claim 3 or 4, wherein the thermoelectric cell (100) further comprises electrically conductive terminals (132) placed at the ends of the first serpentine arrangement, in electrical contact with the thermoelectric elements (110),
the MEMS thermoelectric generator also comprising:
- for each electrically conductive terminal (132), a respective lead (45) extending, laterally to the thermoelectric cell (100), on the heat sink (14) so that it is electrically insulated with respect to the heat sink (14) or on a PCB (64) fixed to the heat sink (14), the total thermoplastic layer (20; 20, 48) also extending on the leads (45); and
- for each electrically conductive terminal (132), a respective electrical connection structure (40) of metal material, which extends at least partially into the total thermoplastic layer (20; 20, 48) and which electrically couples the respective electrically conductive terminal (132) with the respective lead (45).

6. The MEMS thermoelectric generator according to claim 5, wherein the total thermoplastic layer (20) is formed by a first thermoplastic layer (20) having said top surface (20a) and said bottom surface (20b),
wherein the thermal via (30) is formed by a first thermal via (30) having a first end (30') and a second end (30") opposite to each other along the first axis (Z), the first end (30') of the first thermal via (30) facing the top surface (20a) of the first thermoplastic layer (20) and the second end (30") of the first thermal via (30) being in contact with the electrically insulating layer (120, 130) so that it is superimposed, along the first axis (Z), on the first end (110') of each thermoelectric element (110),
wherein each electrical connection structure (40) comprises a first electrical via (41), a second electrical via (42) and an electrical connection portion (43) which joins the first (41) and the second (42) electrical vias,
wherein the first electrical via (41) extends, laterally to the first thermal via (30), through the first thermoplastic layer (20) from the top surface (20a) of the first thermoplastic layer (20) to the thermoelectric cell (100) so that it is in electrical contact with the respective electrically conductive terminal (132),
wherein the second electrical via (42) extends, laterally to the first electrical via (41), through the first thermoplastic layer (20) from the top surface (20a) of the first thermoplastic layer (20) to the respective lead (45) so that it is in electrical contact with the respective lead (45),
wherein the electrical connection portion (43) extends on the top surface (20a) of the first thermoplastic layer (20) between the first (41) and the second (42) electrical vias so that it electrically contacts each other, and
wherein an insulation layer (44), of insulating material, extends on the electrical connection portion (43).

7. The MEMS thermoelectric generator according to claim 5, wherein the total thermoplastic layer (20, 48) is formed by a first thermoplastic layer (20) and by a second thermoplastic layer (48) extending on the first thermoplastic layer (20) and integral with the first thermoplastic layer (20), the first thermoplastic layer (20) defining said bottom surface (20b) of the total thermoplastic layer (20, 48) and the second thermoplastic layer (48) defining said top surface (52a) and,
wherein the thermal via (30, 50) is formed by a first thermal via (30) and by a second thermal via (50) extending on the first thermal via (30) and integral with the first thermal via (30), the first thermal via (30) extending through the first thermoplastic layer (20) and the second thermal via (50) extending through the second thermoplastic layer (48), the thermal via (30, 50) having a first end (50') and a second end (30") opposite to each other along the first axis (Z), the first end (50') of the thermal via (30, 50) being part of the second thermal via (50) and facing the top surface (52a) of the total thermoplastic layer (20, 48) and the second end (30") of the thermal via (30, 50) being part of the first thermal via (30) and being in contact with the electrically insulating layer (120, 130) so that it is superimposed, along the first axis (Z), on the first end (110') of each thermoelectric element (110),
wherein each electrical connection structure (40) comprises a first electrical via (41), a second electrical via (42) and an electrical connection via (43) which is interposed, along the first axis (Z), between the first (20) and the second (48) thermoplastic layers and which joins the first (41) and the second (42) electrical vias,
wherein the first electrical via (41) extends, laterally to the first thermal via (30), through the first thermoplastic layer (20) from the electrical connection portion (43) to the thermoelectric cell (100) so that it is in electrical contact with the respective electrically conductive terminal (132),
wherein the second electrical via (42) extends, laterally to the first electrical via (41), through the first thermoplastic layer (20) from the electrical connection portion (43) to the respective lead (45) so that it is in electrical contact with the respective lead (45), and
wherein the electrical connection portion (43) extends, along the second axis (X), between the first (41) and the second (42) electrical vias so that it electrically contacts each other.

8. The MEMS thermoelectric generator according to claim 5, wherein each electrical connection structure (40) comprises a respective conductive wire (66) of metal material, extending into the total thermoplastic layer (20) and having a first end (66a) and a second end (66b) opposite to each other, the first end (66a) of the conductive wire (66) being fixed to the respective electrically conductive terminal (132) and the second end (66b) of the conductive wire (66) being fixed to the respective lead (45).

9. The MEMS thermoelectric generator according to any of the preceding claims, wherein the one or more thermoelectric elements (110) are of polysilicon or polysilicon-germanium.

10. A manufacturing process of a MEMS thermoelectric generator (10), comprising the steps of:
- forming, on a first surface (105a) of a substrate (105) of semiconductor material, an electrically insulating layer (120, 130) of electrically insulating material, the substrate (105) also having a second surface (105b) opposite to the first surface (105a) along a first axis (Z), wherein one or more thermoelectric elements (110) of thermoelectric material extend into the electrically insulating layer (120, 130), each thermoelectric element (110) having a first end (110') and a second end (110") opposite to each other along a second axis (X) orthogonal to the first axis (Z) and being configured to convert a thermal drop between the first (110') and the second (110") ends into an electric potential between the first (110') and the second (110") ends by the Seebeck effect; and
- forming, in the substrate (105), a cavity (115) which extends from the second surface (105b) of the substrate (105) up to the first surface (105a) of the substrate (105),
wherein the first end (110') of each thermoelectric element (110) is superimposed, along the first axis (Z), on the cavity (115) and the second end (110") of each thermoelectric element (110) is superimposed, along the first axis (Z), on the substrate (105), and
wherein the substrate (105), the electrically insulating layer (120, 130) and the one or more thermoelectric elements (110) define a thermoelectric cell (100) of the MEMS thermoelectric generator (10),
the manufacturing process further comprising the steps of:
- coupling the thermoelectric cell (100) to a heat sink (14) configured to exchange heat with the thermoelectric cell (100), the heat sink (14) facing the second surface (105b) of the substrate (105);
- forming, on the electrically insulating layer (120, 130) a total thermoplastic layer (20; 20, 48) having a top surface (20a; 52a) and a bottom surface (20b) opposite to each other along the first axis (Z), the bottom surface (20b) of the electrically insulating layer (120, 130) facing the electrically insulating layer (120, 130), the total thermoplastic layer (20; 20, 48) being of thermally insulating material and configured to be processed by laser direct structuring, LDS, technique; and
- forming, in the total thermoplastic layer (20; 20, 48), a thermal via (30; 30, 50) of metal material, which extends from the top surface (20a; 52a) to the bottom surface (20b) of the total thermoplastic layer (20; 20, 48) so that it is superimposed, along the first axis (Z), on the first end (110') of each thermoelectric element (110),
wherein the MEMS thermoelectric generator (10) is coupleable to a thermal source (12) in such a way that the top surface (20a; 52a) of the total thermoplastic layer (20; 20, 48) faces the thermal source (12) and the thermoelectric cell (100) exchanges heat, through the thermal via (30; 30, 50), with the thermal source (12) to generate the thermal drop between the first (110') and the second (110") ends of each thermoelectric element (110).

11. The manufacturing process according to claim 10, wherein the step of forming the electrically insulating layer (120, 130) comprises:
a. forming, on the first surface (105a) of the substrate (105), a bottom electrically insulating layer (120) of electrically insulating material;
b. forming, on the bottom electrically insulating layer (120), a thermoelectric material layer (204) of thermoelectric material;
c. forming, in the thermoelectric material layer (204), at least one first doped portion (206N) by doping at least one respective first exposed region (204N) of the thermoelectric material layer (204) with doping species having a first type of electrical conductivity;
d. removing the thermoelectric material layer (204) leaving the at least one first doped portion (206N) on the bottom electrically insulating layer (120), each first doped portion (206N) forming a respective thermoelectric element (110N) with the first type of conductivity of said thermoelectric elements (110);
e. forming, on the bottom electrically insulating layer (120) and on each thermoelectric element (110), a first insulating layer (129) of electrically insulating material which is comprised in a top electrically insulating layer (130), the bottom electrically insulating layer (120) and the top electrically insulating layer (130) defining said electrically insulating layer (120, 130).

12. The manufacturing process according to claim 11, wherein the step of forming the electrically insulating layer (120, 130) further comprises:
- between step c. and d., forming in the thermoelectric material layer (204) at least one second doped portion (206P) by doping, with further doping species having a second type of electrical conductivity opposite to the first type, at least one second exposed region (204P) of the thermoelectric material layer (204), lateral to the at least one first exposed region (204N);
- during step d., removing the thermoelectric material layer (204) leaving both the at least one first doped portion (206N) and the at least one second doped portion (206P) on the bottom electrically insulating layer (120), each second doped portion (206P) forming a respective thermoelectric element (110P) with the second type of conductivity of said thermoelectric elements (110);
- after step e., forming, through the first insulating layer (129), at least one electrically conductive element (125) of conductive material, which electrically contacts a respective thermoelectric element (110N) with the first type of conductivity and a respective thermoelectric element (110P) with the second type of conductivity to interconnect them; and
- forming, on the first insulating layer (129) and on the at least one electrically conductive element (125), one or more second insulating layers of electrically insulating material which define, with the first insulating layer (129), said top electrically insulating layer (130).

13. The manufacturing process according to any of claims 10-12, wherein the step of forming the cavity (115) in the substrate (105) comprises:
- temporarily coupling the thermoelectric cell (100) to a transport wafer (216), the transport wafer (216) facing the electrically insulating layer (120, 130) of the thermoelectric cell (100);
- performing an etching at a cavity region (220) of the second surface (105b) of the substrate (105) to form the cavity (115), the cavity region (220) being aligned along the first axis (Z) with the first end (110') of each thermoelectric element (110); and
- decoupling the thermoelectric cell (100) and the transport wafer (216) from each other.

14. The manufacturing process according to any of claims 10-13, wherein the step of forming a total thermoplastic layer (20; 20, 48) comprises forming a first thermoplastic layer (20) on the electrically insulating layer (120, 130) by injection molding, the first thermoplastic layer (20) defining the total thermoplastic layer (20) or being comprised in the total thermoplastic layer (20, 48).

15. The manufacturing process according to claim 14, wherein the step of forming the thermal via (30; 30, 50) in the total thermoplastic layer (20; 20, 48) comprises:
- forming a first trench (140) in the first thermoplastic layer (20), from a top surface (20a) up to a bottom surface (20b) of the first thermoplastic layer (20), the first trench (140) being formed by radiating through laser with LDS technique a first trench region of the top surface (20a) of the first thermoplastic layer (20) to selectively remove a corresponding part of the first thermoplastic layer (20), the first trench region being superimposed, along the first axis (Z), on the cavity (115); and
- performing a metal deposition in the first trench (140) to form a first thermal via (30), the first thermal via (30) being the thermal via (30) or being part of the thermal via (30, 50).

16. The manufacturing process according to claim 15, wherein the thermoelectric cell (100) comprises a plurality of said thermoelectric elements (110) interconnected to form a serpentine arrangement,
the manufacturing process further comprising the steps of:
- forming, in the electrically insulating layer (120, 130), electrically conductive terminals (132) placed at the ends of the serpentine arrangement and exposed by the electrically insulating layer (120, 130);
- for each electrically conductive terminal (132), forming a respective second trench (141) and a respective third trench (142) in the first thermoplastic layer (20), from the top surface (20a) up to the bottom surface (20b) of the first thermoplastic layer (20), the respective second (141) and third (142) trenches being arranged laterally to the first trench (140) and being formed by radiating through laser with LDS technique respective second and third trench regions of the top surface (20a) of the first thermoplastic layer (20) to selectively remove corresponding parts of the first thermoplastic layer (20), the respective second and third trench regions being superimposed, along the first axis (Z), on the respective electrically conductive terminal (132) and, respectively, on a respective lead (45) extending on the heat sink (14) laterally to the thermoelectric cell (100), the first thermoplastic layer (20) also being formed on the respective lead (45);
- for each electrically conductive terminal (132), chemically activating, by laser radiation with LDS technique, a respective activated region (143) of the top surface (20a) of the first thermoplastic layer (20), which extends between the respective second and third trench regions; and
- performing a metal deposition in the second (141) and third (142) trenches to form respective first (41) and second (42) electrical vias, and on the activated regions (143) to form respective electrical connection portions (43) interposed along the second axis (X) between the respective first (41) and second (42) electrical vias, the respective first (41) and second (42) electrical vias and the respective electrical connection portions (43) forming together respective electrical connection structures (40) which electrically connect the respective electrically conductive terminals (132) and the respective leads (45) to each other.

17. The manufacturing process according to claim 16, further comprising the step of forming an insulation layer (44) of insulating material on each of the electrical connection structures (40), or
also comprising the steps of:
- forming by injection molding a second thermoplastic layer (48) on the first thermoplastic layer (20), on the electrical connection structures (40) and on the first thermal via (30), the second thermoplastic layer (48) forming with the first thermoplastic layer (20) said total thermoplastic layer (20, 48); and
- forming, in the second thermoplastic layer (48), a second thermal via (50) of metal material, superimposed, along the first axis (Z), on the first thermal via (50), the first (30) and the second (50) thermal vias forming said thermal via (30, 50).

18. The manufacturing process according to any of claims 10-15, wherein the thermoelectric cell (100) comprises a plurality of said thermoelectric elements (110) interconnected to form a serpentine arrangement,
the manufacturing process further comprising, before forming the total thermoplastic layer (20) on the electrically insulating layer (120, 130), the steps of:
- forming, in the electrically insulating layer (120, 130), electrically conductive terminals (132) placed at the ends of the serpentine arrangement and exposed by the electrically insulating layer (120, 130);
- fixing to each electrically conductive terminal (132) a first end (66a) of a respective conductive wire (66), and to a respective lead (45) a second end (66a) of said respective conductive wire (66), the first (66a) and the second (66b) ends of each conductive wire (66) being opposite to each other, each lead (45) extending on the heat sink (14) laterally to the thermoelectric cell (100); and
- forming the total thermoplastic layer (20) also on the conductive wires (66).

19. A heating system (500) comprising a heating apparatus (502) and a control apparatus (504) including a MEMS thermoelectric generator (10), according to any of claims 1-9, coupled to the heating apparatus (502) to exchange heat with the heating apparatus (502), the heating apparatus (502) being said thermal source (12).

## Patentansprüche

1. Thermoelektrischer MEMS-Generator (10), der mindestens eine thermoelektrische Zelle (100) umfasst, welche beinhaltet:
- ein Substrat (105) aus Halbleitermaterial, das eine erste Fläche (105a) und eine zweite Fläche (105b) aufweist, die einander entlang einer ersten Achse (Z) gegenüberliegen, wobei sich ein Hohlraum (115) entlang der ersten Achse (Z) von der zweiten Fläche (105b) bis zur ersten Fläche (105a) in das Substrat (105) erstreckt;
- eine elektrisch isolierende Schicht (120, 130) aus elektrisch isolierendem Material, die sich auf der ersten Fläche (105a) des Substrats (105) und auf dem Hohlraum (115) erstreckt;
- ein oder mehrere thermoelektrische Elemente (110) aus thermoelektrischem Material, wobei sich jedes thermoelektrische Element (110) in die elektrisch isolierende Schicht (120, 130) erstreckt, ein erstes Ende (110') und ein zweites Ende (110") aufweist, die einander entlang einer zweiten Achse (X) orthogonal zur ersten Achse (Z) gegenüberliegen, und so konfiguriert ist, dass es einen thermischen Abfall zwischen dem ersten (110') und dem zweiten (110") Ende durch den Seebeck-Effekt in ein elektrisches Potential zwischen dem ersten (110') und dem zweiten (110") Ende umwandelt,
wobei das erste Ende (110') jedes thermoelektrischen Elements (110) entlang der ersten Achse (Z) dem Hohlraum (115) überlagert ist und das zweite Ende (110") jedes thermoelektrischen Elements (110) entlang der ersten Achse (Z) dem Substrat (105) überlagert ist,
wobei der thermoelektrische MEMS-Generator (10) weiter umfasst:
- eine thermoplastische Gesamtschicht (20; 20, 48), die sich auf der elektrisch isolierenden Schicht (120, 130) erstreckt und eine obere Fläche (20a; 52a) und eine untere Fläche (20b) aufweist, die einander entlang der ersten Achse (Z) gegenüberliegen, wobei die untere Fläche (20b) der elektrisch isolierenden Schicht (120, 130) der elektrisch isolierenden Schicht (120, 130) zugewandt ist, wobei die thermoplastische Gesamtschicht (20; 20, 48) aus thermisch isolierendem Material besteht und so konfiguriert ist, dass sie durch Laserdirektstrukturierungs-, LDS-, Technik verarbeitet werden kann;
- eine Wärmesenke (14), die mit der thermoelektrischen Zelle gekoppelt und so konfiguriert ist, dass sie mit der thermoelektrischen Zelle (100), die sich entlang der ersten Achse (Z) zwischen der Wärmesenke (14) und der thermoplastischen Gesamtschicht (20; 20, 48) erstreckt, Wärme austauscht; und
- eine thermische Durchkontaktierung (30; 30, 50) aus metallischem Material, die sich so durch die thermoplastische Gesamtschicht (20; 20, 48) von der oberen Fläche (20a; 52a) zur unteren Fläche (20b) der thermoplastischen Gesamtschicht (20; 20, 48) erstreckt, dass sie entlang der ersten Achse (Z) dem ersten Ende (110') jedes thermoelektrischen Elements (110) überlagert ist,
wobei der thermoelektrische MEMS-Generator (10) derart mit einer thermischen Quelle (12) gekoppelt werden kann, dass die obere Fläche (20a; 52a) der thermoplastischen Gesamtschicht (20; 20, 48) der thermischen Quelle (12) zugewandt ist und die thermoelektrische Zelle (100) durch die thermische Durchkontaktierung (30; 30, 50) Wärme mit der thermischen Quelle (12) austauscht, um den thermischen Abfall zwischen dem ersten (110') und dem zweiten (110") Ende jedes thermoelektrischen Elements (110) zu erzeugen.

2. Thermoelektrischer MEMS-Generator nach Anspruch 1, wobei die thermoplastische Gesamtschicht (20; 20, 48) aus thermoplastischem polymerem Material besteht, das mit organisch-metallischen Verbindungen dotiert ist, die so konfiguriert sind, dass sie chemisch aktiviert werden, wenn sie von einem Laserstrahl bestrahlt werden.

3. Thermoelektrischer MEMS-Generator nach Anspruch 1 oder 2, wobei die thermoelektrische Zelle (100) eine erste Vielzahl der thermoelektrischen Elemente (110) umfasst,
wobei die erste Vielzahl von thermoelektrischen Elementen (110) eine jeweilige erste Vielzahl von thermoelektrischen Mikrostrukturen (110N', 110P') umfasst, die durch elektrisch leitfähige Elemente (125) so miteinander verbunden sind, dass sie eine erste schlangenförmige Anordnung bilden,
wobei die erste Vielzahl von thermoelektrischen Mikrostrukturen (110N', 110P') thermoelektrische Mikrostrukturen (110N'; 110P'), die eine erste Art von elektrischer Leitfähigkeit aufweisen, und thermoelektrische Mikrostrukturen (110P'; 110N') umfasst, die eine zweite Art von elektrischer Leitfähigkeit aufweisen, die der ersten Art entgegengesetzt ist, wobei die thermoelektrischen Mikrostrukturen (110N'; 110P') mit der ersten Art von elektrischer Leitfähigkeit und die thermoelektrischen Mikrostrukturen (110P'; 110N') mit der zweiten Art von elektrischer Leitfähigkeit entlang der ersten schlangenförmigen Anordnung miteinander abwechseln, und
wobei die thermoelektrischen Elemente (110) und die elektrisch leitfähigen Elemente (125) in der elektrisch isolierenden Schicht (120, 130) vergraben sind.

4. Thermoelektrischer MEMS-Generator nach Anspruch 3, wobei die thermoelektrische Zelle (100) weiter eine zweite Vielzahl der thermoelektrischen Elemente (110) umfasst,
wobei die zweite Vielzahl von thermoelektrischen Elementen (110) eine jeweilige zweite Vielzahl von thermoelektrischen Mikrostrukturen (110N", 110P") umfasst,
die durch jeweilige elektrisch leitfähige Elemente (125) so miteinander verbunden sind, dass sie eine zweite schlangenförmige Anordnung bilden,
wobei die zweite Vielzahl von thermoelektrischen Mikrostrukturen (110N", 110P") jeweilige thermoelektrische Mikrostrukturen (110N"; 110P"), die die erste Art von elektrischer Leitfähigkeit aufweisen, und jeweilige thermoelektrische Mikrostrukturen (110P"; 110N") umfasst, die die zweite Art von elektrischer Leitfähigkeit aufweisen, wobei die thermoelektrischen Mikrostrukturen (110N"; 110P") mit der ersten Art von elektrischer Leitfähigkeit und die thermoelektrischen Mikrostrukturen (110P"; 110N") mit der zweiten Art von elektrischer Leitfähigkeit entlang der zweiten schlangenförmigen Anordnung miteinander abwechseln,
wobei die erste Vielzahl von thermoelektrischen Mikrostrukturen (110N', 110P') entlang der ersten Achse (Z) der zweiten Vielzahl von thermoelektrischen Mikrostrukturen (110N", 110P") überlagert ist, und
wobei die thermoelektrischen Mikrostrukturen (110N', 110P') der ersten Vielzahl und der zweiten Vielzahl elektrisch miteinander angeordnet sind: in Reihe, wobei die erste und die zweite schlangenförmige Anordnung zusammenfallen; oder parallel.

5. Thermoelektrischer MEMS-Generator nach Anspruch 3 oder 4, wobei die thermoelektrische Zelle (100) weiter elektrisch leitfähige Anschlüsse (132), die an den Enden der ersten schlangenförmigen Anordnung platziert sind, in elektrischem Kontakt mit den thermoelektrischen Elementen (110) umfasst,
wobei der thermoelektrische MEMS-Generator auch umfasst:
- für jeden elektrisch leitfähigen Anschluss (132) eine jeweilige Leitung (45), die sich seitlich zur thermoelektrischen Zelle (100) so an der Wärmesenke (14) erstreckt, dass sie in Bezug auf die Wärmesenke (14) elektrisch isoliert ist, oder an einer Leiterplatte (64), die an der Wärmesenke (14) befestigt ist, erstreckt, wobei sich die thermoplastische Gesamtschicht (20; 20, 48) auch auf den Leitungen (45) erstreckt; und
- für jeden elektrisch leitfähigen Anschluss (132) eine jeweilige elektrische Verbindungsstruktur (40) aus metallischem Material, die sich mindestens teilweise in die thermoplastische Gesamtschicht (20; 20, 48) erstreckt und die den jeweiligen elektrisch leitfähigen Anschluss (132) elektrisch mit der jeweiligen Leitung (45) koppelt.

6. Thermoelektrischer MEMS-Generator nach Anspruch 5, wobei die thermoplastische Gesamtschicht (20) von einer ersten thermoplastischen Schicht (20) gebildet wird, die die obere Fläche (20a) und die untere Fläche (20b) aufweist,
wobei die thermische Durchkontaktierung (30) von einer ersten thermischen Durchkontaktierung (30) gebildet wird, die ein erstes Ende (30') und ein zweites Ende (30") aufweist, die einander entlang der ersten Achse (Z) gegenüberliegen, wobei das erste Ende (30') der ersten thermischen Durchkontaktierung (30) der oberen Fläche (20a) der ersten thermoplastischen Schicht (20) zugewandt ist und das zweite Ende (30") der ersten thermischen Durchkontaktierung (30) so mit der elektrisch isolierenden Schicht (120, 130) in Kontakt steht, dass es entlang der ersten Achse (Z) dem ersten Ende (110') jedes thermoelektrischen Elements (110) überlagert ist,
wobei jede elektrische Verbindungsstruktur (40) eine erste elektrische Durchkontaktierung (41), eine zweite elektrische Durchkontaktierung (42) und einen elektrischen Verbindungsabschnitt (43) umfasst, der die erste (41) und die zweite (42) elektrische Durchkontaktierung miteinander verbindet,
wobei sich die erste elektrische Durchkontaktierung (41) seitlich zur ersten thermischen Durchkontaktierung (30) so durch die erste thermoplastische Schicht (20) von der oberen Fläche (20a) der ersten thermoplastischen Schicht (20) zur thermoelektrischen Zelle (100) erstreckt, dass sie mit dem jeweiligen elektrisch leitfähigen Anschluss (132) in elektrischem Kontakt steht,
wobei sich die zweite elektrische Durchkontaktierung (42) seitlich zur ersten elektrischen Durchkontaktierung (41) so durch die erste thermoplastische Schicht (20) von der oberen Fläche (20a) der ersten thermoplastischen Schicht (20) zur jeweiligen Leitung (45) erstreckt, dass sie mit der jeweiligen Leitung (45) in elektrischem Kontakt steht,
wobei sich der elektrische Verbindungsabschnitt (43) auf der oberen Fläche (20a) der ersten thermoplastischen Schicht (20) so zwischen der ersten (41) und der zweiten (42) elektrischen Durchkontaktierung erstreckt, dass er diese elektrisch miteinander kontaktiert, und
wobei sich eine Isolierschicht (44) aus isolierendem Material auf dem elektrischen Verbindungsabschnitt (43) erstreckt.

7. Thermoelektrischer MEMS-Generator nach Anspruch 5, wobei die thermoplastische Gesamtschicht (20, 48) von einer ersten thermoplastischen Schicht (20) und von einer zweiten thermoplastischen Schicht (48) gebildet wird, die sich auf der ersten thermoplastischen Schicht (20) erstreckt und mit der ersten thermoplastischen Schicht (20) einstückig ist, wobei die erste thermoplastische Schicht (20) die untere Fläche (20b) der thermoplastischen Gesamtschicht (20, 48) definiert und die zweite thermoplastische Schicht (48) die obere Fläche (52a) definiert, und
wobei die thermische Durchkontaktierung (30, 50) von einer ersten thermischen Durchkontaktierung (30) und von einer zweiten thermischen Durchkontaktierung (50) gebildet wird, die sich auf der ersten thermischen Durchkontaktierung (30) erstreckt und mit der ersten thermischen Durchkontaktierung (30) einstückig ist, wobei sich die erste thermische Durchkontaktierung (30) durch die erste thermoplastische Schicht (20) erstreckt und die zweite thermische Durchkontaktierung (50) sich durch die zweite thermoplastische Schicht (48) erstreckt, wobei die thermische Durchkontaktierung (30, 50) ein erstes Ende (50') und ein zweites Ende (30") aufweist, die einander entlang der ersten Achse (Z) gegenüberliegen, wobei das erste Ende (50') der thermischen Durchkontaktierung (30, 50) Teil der zweiten thermischen Durchkontaktierung (50) ist und der oberen Fläche (52a) der thermoplastischen Gesamtschicht (20, 48) zugewandt ist, und das zweite Ende (30") der thermischen Durchkontaktierung (30, 50) Teil der ersten thermischen Durchkontaktierung (30) ist und mit der elektrisch isolierenden Schicht (120, 130) so in Kontakt steht, dass sie entlang der ersten Achse (Z) dem ersten Ende (110') jedes thermoelektrischen Elements (110) überlagert ist, wobei jede elektrische Verbindungsstruktur (40) eine erste elektrische Durchkontaktierung (41), eine zweite elektrische Durchkontaktierung (42) und eine elektrische Verbindungsdurchkontaktierung (43) umfasst, die entlang der ersten Achse (Z) zwischen der ersten (20) und der zweiten (48) thermoplastischen Schicht eingefügt ist und die die erste (41) und die zweite (42) elektrische Durchkontaktierung miteinander verbindet,
wobei sich die erste elektrische Durchkontaktierung (41) seitlich zur ersten thermischen Durchkontaktierung (30) so durch die erste thermoplastische Schicht (20) vom elektrischen Verbindungsabschnitt (43) zur thermoelektrischen Zelle (100) erstreckt, dass sie mit dem jeweiligen elektrisch leitfähigen Anschluss (132) in elektrischem Kontakt steht,
wobei sich die zweite elektrische Durchkontaktierung (42) seitlich zur ersten elektrischen Durchkontaktierung (41) so durch die erste thermoplastische Schicht (20) vom elektrischen Verbindungsabschnitt (43) zur jeweiligen Leitung (45) erstreckt, dass sie mit der jeweiligen Leitung (45) in elektrischem Kontakt steht, und
wobei sich der elektrische Verbindungsabschnitt (43) entlang der zweiten Achse (X) so zwischen der ersten (41) und der zweiten (42) elektrischen Durchkontaktierung erstreckt, dass er diese elektrisch miteinander kontaktiert.

8. Thermoelektrischer MEMS-Generator nach Anspruch 5, wobei jede elektrische Verbindungsstruktur (40) einen jeweiligen leitfähigen Draht (66) aus metallischem Material umfasst, der sich in die thermoplastische Gesamtschicht (20) erstreckt und ein erstes Ende (66a) und ein zweites Ende (66b) aufweist, die einander gegenüberliegen, wobei das erste Ende (66a) des leitfähigen Drahtes (66) an dem jeweiligen elektrisch leitfähigen Anschluss (132) befestigt ist und das zweite Ende (66b) des leitfähigen Drahtes (66) an der jeweiligen Leitung (45) befestigt ist.

9. Thermoelektrischer MEMS-Generator nach einem der vorstehenden Ansprüche, wobei das eine oder die mehreren thermoelektrischen Elemente (110) aus Polysilizium oder Polysilizium-Germanium bestehen.

10. Herstellungsprozess für einen thermoelektrischen MEMS-Generator (10), der die folgenden Schritte umfasst:
- Bilden einer elektrisch isolierenden Schicht (120, 130) aus elektrisch isolierendem Material auf einer ersten Fläche (105a) eines Substrats (105) aus Halbleitermaterial, wobei das Substrat (105) auch eine zweite Fläche (105b) aufweist, die der ersten Fläche (105a) entlang einer ersten Achse (Z) gegenüberliegt, wobei sich ein oder mehrere thermoelektrische Elemente (110) aus thermoelektrischem Material in die elektrisch isolierende Schicht (120, 130) erstrecken, wobei jedes thermoelektrische Element (110) ein erstes Ende (110') und ein zweites Ende (110") aufweist, die einander entlang einer zweiten Achse (X) orthogonal zur ersten Achse (Z) gegenüberliegen, und so konfiguriert ist, dass es einen thermischen Abfall zwischen dem ersten (110') und dem zweiten (110") Ende durch den Seebeck-Effekt in ein elektrisches Potential zwischen dem ersten (110') und dem zweiten (110") Ende umwandelt; und
- Bilden eines Hohlraums (115) im Substrat (105), der sich von der zweiten Fläche (105b) des Substrats (105) bis zur ersten Fläche (105a) des Substrats (105) erstreckt,
wobei das erste Ende (110') jedes thermoelektrischen Elements (110) entlang der ersten Achse (Z) dem Hohlraum (115) überlagert ist und das zweite Ende (110") jedes thermoelektrischen Elements (110) entlang der ersten Achse (Z) dem Substrat (105) überlagert ist, und
wobei das Substrat (105), die elektrisch isolierende Schicht (120, 130) und das eine oder die mehreren thermoelektrischen Elemente (110) eine thermoelektrische Zelle (100) des thermoelektrischen MEMS-Generators (10) definieren,
wobei der Herstellungsprozess weiter die folgenden Schritte umfasst:
- Koppeln der thermoelektrischen Zelle (100) mit einer Wärmesenke (14), die so konfiguriert ist, dass sie Wärme mit der thermoelektrischen Zelle (100) austauscht, wobei die Wärmesenke (14) der zweiten Fläche (105b) des Substrats (105) zugewandt ist;
- Bilden einer thermoplastischen Gesamtschicht (20; 20, 48), die eine obere Fläche (20a; 52a) und eine untere Fläche (20b) aufweist, die einander entlang der ersten Achse (Z) gegenüberliegen, auf der elektrisch isolierenden Schicht (120, 130), wobei die untere Fläche (20b) der elektrisch isolierenden Schicht (120, 130) der elektrisch isolierenden Schicht (120, 130) zugewandt ist, wobei die thermoplastische Gesamtschicht (20; 20, 48) aus thermisch isolierendem Material besteht und so konfiguriert ist, dass sie durch Laserdirektstrukturierungs-, LDS-, Technik verarbeitet werden kann; und
- Bilden einer thermischen Durchkontaktierung (30; 30, 50) aus metallischem Material in der thermoplastischen Gesamtschicht (20; 20, 48), die sich so von der oberen Fläche (20a; 52a) zur unteren Fläche (20b) der thermoplastischen Gesamtschicht (20; 20, 48) erstreckt, dass sie entlang der ersten Achse (Z) dem ersten Ende (110') jedes thermoelektrischen Elements (110) überlagert ist,
wobei der thermoelektrische MEMS-Generator (10) derart mit einer thermischen Quelle (12) gekoppelt werden kann, dass die obere Fläche (20a; 52a) der thermoplastischen Gesamtschicht (20; 20, 48) der thermischen Quelle (12) zugewandt ist und die thermoelektrische Zelle (100) durch die thermische Durchkontaktierung (30; 30, 50) Wärme mit der thermischen Quelle (12) austauscht, um den thermischen Abfall zwischen dem ersten (110') und dem zweiten (110") Ende jedes thermoelektrischen Elements (110) zu erzeugen.

11. Herstellungsprozess nach Anspruch 10, wobei der Schritt des Bildens der elektrisch isolierenden Schicht (120, 130) umfasst:
a. Bilden einer unteren elektrisch isolierenden Schicht (120) aus elektrisch isolierendem Material auf der ersten Fläche (105a) des Substrats (105);
b. Bilden einer thermoelektrischen Materialschicht (204) aus thermoelektrischem Material auf der unteren elektrisch isolierenden Schicht (120);
c. Bilden mindestens eines ersten dotierten Abschnitts (206N) in der thermoelektrischen Materialschicht (204) durch Dotieren mindestens eines jeweiligen ersten freiliegenden Bereichs (204N) der thermoelektrischen Materialschicht (204) mit Dotierungsspezies, die eine erste Art von elektrischer Leitfähigkeit aufweisen;
d. Entfernen der thermoelektrischen Materialschicht (204), wobei der mindestens eine erste dotierte Abschnitt (206N) an der unteren elektrisch isolierenden Schicht (120) belassen wird, wobei jeder erste dotierte Abschnitt (206N) ein jeweiliges thermoelektrisches Element (110N) mit der ersten Art von Leitfähigkeit der thermoelektrischen Elemente (110) bildet;
e. Bilden einer ersten isolierenden Schicht (129) aus elektrisch isolierendem Material, die in einer oberen elektrisch isolierenden Schicht (130) umfasst ist, auf der unteren elektrisch isolierenden Schicht (120) und auf jedem thermoelektrischen Element (110), wobei die untere elektrisch isolierende Schicht (120) und die obere elektrisch isolierende Schicht (130) die elektrisch isolierende Schicht (120, 130) definieren.

12. Herstellungsprozess nach Anspruch 11, wobei der Schritt des Bildens der elektrisch isolierenden Schicht (120, 130) weiter umfasst:
- zwischen Schritt c. und d., Bilden mindestens eines zweiten dotierten Abschnitts (206P) in der thermoelektrischen Materialschicht (204) durch Dotieren mindestens eines zweiten freiliegenden Bereichs (204P) der thermoelektrischen Materialschicht (204) seitlich zu dem mindestens einen ersten freiliegenden Bereich (204N) mit weiteren Dotierungsspezies, die eine zweite Art von elektrischer Leitfähigkeit aufweisen, die der ersten Art entgegengesetzt ist;
- während Schritt d., Entfernen der thermoelektrischen Materialschicht (204), wobei sowohl der mindestens eine erste dotierte Abschnitt (206N) als auch der mindestens eine zweite dotierte Abschnitt (206P) auf der unteren elektrisch isolierenden Schicht (120) belassen werden, wobei jeder zweite dotierte Abschnitt (206P) ein jeweiliges thermoelektrisches Element (110P) mit der zweiten Art von Leitfähigkeit der thermoelektrischen Elemente (110) bildet;
- nach Schritt e., Bilden mindestens eines elektrisch leitfähigen Elements (125) aus leitfähigem Material, das ein jeweiliges thermoelektrisches Element (110N) mit der ersten Art von Leitfähigkeit und ein jeweiliges thermoelektrisches Element (110P) mit der zweiten Art von Leitfähigkeit elektrisch kontaktiert, durch die erste isolierende Schicht (129), um sie miteinander zu verbinden; und
- Bilden einer oder mehrerer zweiter isolierender Schichten aus elektrisch isolierendem Material, die zusammen mit der ersten isolierenden Schicht (129) die obere elektrisch isolierende Schicht (130) definieren, auf der ersten isolierenden Schicht (129) und auf dem mindestens einen elektrisch leitfähigen Element (125).

13. Herstellungsprozess nach einem der Ansprüche 10-12, wobei der Schritt des Bildens des Hohlraums (115) im Substrat (105) umfasst:
- temporäres Koppeln der thermoelektrischen Zelle (100) mit einem Transportwafer (216), wobei der Transportwafer (216) der elektrisch isolierenden Schicht (120, 130) der thermoelektrischen Zelle (100) zugewandt ist;
- Durchführen eines Ätzens an einem Hohlraumbereich (220) der zweiten Fläche (105b) des Substrats (105), um den Hohlraum (115) zu bilden, wobei der Hohlraumbereich (220) entlang der ersten Achse (Z) mit dem ersten Ende (110') jedes thermoelektrischen Elements (110) ausgerichtet ist; und
- Entkoppeln der thermoelektrischen Zelle (100) und des Transportwafers (216) voneinander.

14. Herstellungsprozess nach einem der Ansprüche 10-13, wobei der Schritt des Bildens einer thermoplastischen Gesamtschicht (20; 20, 48) das Bilden einer ersten thermoplastischen Schicht (20) auf der elektrisch isolierenden Schicht (120, 130) durch Spritzgießen umfasst, wobei die erste thermoplastische Schicht (20) die thermoplastische Gesamtschicht (20) definiert oder in der thermoplastischen Gesamtschicht (20, 48) umfasst ist.

15. Herstellungsprozess nach Anspruch 14, wobei der Schritt des Bildens der thermischen Durchkontaktierung (30; 30, 50) in der thermoplastischen Gesamtschicht (20; 20, 48) umfasst:
- Bilden eines ersten Grabens (140) in der ersten thermoplastischen Schicht (20) von einer oberen Fläche (20a) bis zu einer unteren Fläche (20b) der ersten thermoplastischen Schicht (20), wobei der erste Graben (140) durch Bestrahlen eines ersten Grabenbereichs der oberen Fläche (20a) der ersten thermoplastischen Schicht (20) durch Laser mit LDS-Technik, um selektiv einen entsprechenden Teil der ersten thermoplastischen Schicht (20) zu entfernen, gebildet wird, wobei der erste Grabenbereich entlang der ersten Achse (Z) dem Hohlraum (115) überlagert ist; und
- Durchführen einer Metallabscheidung im ersten Graben (140), um eine erste thermische Durchkontaktierung (30) zu bilden, wobei die erste thermische Durchkontaktierung (30) die thermische Durchkontaktierung (30) ist oder Teil der thermischen Durchkontaktierung (30, 50) ist.

16. Herstellungsprozess nach Anspruch 15, wobei die thermoelektrische Zelle (100) eine Vielzahl der thermoelektrischen Elemente (110) umfasst, die so miteinander verbunden sind, dass sie eine schlangenförmige Anordnung bilden,
wobei der Herstellungsprozess weiter die folgenden Schritte umfasst:
- Bilden von elektrisch leitfähigen Anschlüssen (132), die an den Enden der schlangenförmigen Anordnung platziert sind und von der elektrisch isolierenden Schicht (120, 130) freigelegt werden, in der elektrisch isolierenden Schicht (120, 130);
- Bilden, für jeden elektrisch leitfähigen Anschluss (132), eines jeweiligen zweiten Grabens (141) und eines jeweiligen dritten Grabens (142) in der ersten thermoplastischen Schicht (20) von der oberen Fläche (20a) bis zur unteren Fläche (20b) der ersten thermoplastischen Schicht (20), wobei der jeweilige zweite (141) und dritte (142) Graben seitlich zum ersten Graben (140) angeordnet sind und durch Bestrahlen von jeweiligen zweiten und dritten Grabenbereichen der oberen Fläche (20a) der ersten thermoplastischen Schicht (20) durch Laser mit LDS-Technik, um selektiv entsprechende Teile der ersten thermoplastischen Schicht (20) zu entfernen, gebildet werden, wobei der jeweilige zweite und dritte Grabenbereich entlang der ersten Achse (Z) dem jeweiligen elektrisch leitfähigen Anschluss (132) bzw. einer jeweiligen Leitung (45), die sich an der Wärmesenke (14) seitlich zur thermoelektrischen Zelle (100) erstreckt, überlagert sind, wobei die erste thermoplastische Schicht (20) auch auf der jeweiligen Leitung (45) gebildet wird;
- chemisches Aktivieren, für jeden elektrisch leitfähigen Anschluss (132), eines jeweiligen aktivierten Bereichs (143) der oberen Fläche (20a) der ersten thermoplastischen Schicht (20), der sich zwischen dem jeweiligen zweiten und dritten Grabenbereich erstreckt, durch Laserstrahlung mit LDS-Technik; und
- Durchführen einer Metallabscheidung im zweiten (141) und dem dritten (142) Graben, um eine jeweilige erste (41) und zweite (42) elektrische Durchkontaktierung zu bilden, und auf den aktivierten Bereichen (143), um jeweilige elektrische Verbindungsabschnitte (43) zu bilden, die entlang der zweiten Achse (X) zwischen der jeweiligen ersten (41) und zweiten (42) elektrischen Durchkontaktierung eingefügt sind, wobei die jeweiligen erste (41) und zweite (42) elektrische Durchkontaktierung und die jeweiligen elektrischen Verbindungsabschnitte (43) zusammen jeweilige elektrische Verbindungsstrukturen (40) bilden, die die jeweiligen elektrisch leitfähigen Anschlüsse (132) und die jeweiligen Leitungen (45) elektrisch miteinander verbinden.

17. Herstellungsprozess nach Anspruch 16, der weiter den Schritt des Bildens einer Isolierschicht (44) aus isolierendem Material auf jeder der elektrischen Verbindungsstrukturen (40) umfasst, oder
der auch die folgenden Schritte umfasst:
- Bilden einer zweiten thermoplastischen Schicht (48) auf der ersten thermoplastischen Schicht (20), auf den elektrischen Verbindungsstrukturen (40) und auf der ersten thermischen Durchkontaktierung (30) durch Spritzgießen, wobei die zweite thermoplastische Schicht (48) zusammen mit der ersten thermoplastischen Schicht (20) die thermoplastische Gesamtschicht (20, 48) bildet; und
- Bilden einer zweiten thermischen Durchkontaktierung (50) aus metallischem Material, die entlang der ersten Achse (Z) der ersten thermischen Durchkontaktierung (50) überlagert ist, in der zweiten thermoplastischen Schicht (48), wobei die erste (30) und die zweite (50) thermische Durchkontaktierung die thermische Durchkontaktierung (30, 50) bilden.

18. Herstellungsprozess nach einem der Ansprüche 10-15, wobei die thermoelektrische Zelle (100) eine Vielzahl der thermoelektrischen Elemente (110) umfasst, die so miteinander verbunden sind, dass sie eine schlangenförmige Anordnung bilden,
wobei der Herstellungsprozess vor dem Bilden der thermoplastischen Gesamtschicht (20) auf der elektrisch isolierenden Schicht (120, 130) weiter die folgenden Schritte umfasst:
- Bilden von elektrisch leitfähigen Anschlüssen (132), die an den Enden der schlangenförmigen Anordnung platziert sind und von der elektrisch isolierenden Schicht (120, 130) freigelegt werden, in der elektrisch isolierenden Schicht (120, 130);
- Befestigen eines ersten Endes (66a) eines jeweiligen leitfähigen Drahtes (66) an jedem elektrisch leitfähigen Anschluss (132) und eines zweiten Endes (66a) des jeweiligen leitfähigen Drahtes (66) an einer jeweiligen Leitung (45), wobei das erste (66a) und das zweite (66b) Ende jedes leitfähigen Drahtes (66) einander gegenüberliegen, wobei sich jede Leitung (45) an der Wärmesenke (14) seitlich zur thermoelektrischen Zelle (100) erstreckt; und
- Bilden der thermoplastischen Gesamtschicht (20) auch auf den leitfähigen Drähten (66).

19. Heizsystem (500), das eine Heizeinrichtung (502) und eine Steuereinrichtung (504) beinhaltet, die einen thermoelektrischen MEMS-Generator (10) nach einem der Ansprüche 1-9 umfasst, der mit der Heizeinrichtung (502) gekoppelt ist, um mit der Heizeinrichtung (502) Wärme auszutauschen, wobei die Heizeinrichtung (502) die thermische Quelle (12) ist.

## Revendications

1. Générateur thermoélectrique MEMS (10) comprenant au moins une cellule thermoélectrique (100) comportant :
- un substrat (105) en matériau semiconducteur, ayant une première surface (105a) et une deuxième surface (105b) opposées l'une à l'autre le long d'un premier axe (Z), dans lequel une cavité (115) s'étend dans le substrat (105) le long du premier axe (Z) de la deuxième surface (105b) à la première surface (105a) ;
- une couche électriquement isolante (120, 130) en matériau électriquement isolant, s'étendant sur la première surface (105a) du substrat (105) et sur la cavité (115) ;
- un ou plusieurs éléments thermoélectriques (110) en matériau thermoélectrique, chaque élément thermoélectrique (110) s'étendant dans la couche électriquement isolante (120, 130), ayant une première extrémité (110') et une deuxième extrémité (110") opposées l'une à l'autre le long d'un deuxième axe (X) orthogonal au premier axe (Z) et étant configuré pour convertir une chute thermique entre les première (110') et deuxième (110") extrémités en un potentiel électrique entre les première (110') et deuxième (110") extrémités par effet Seebeck,
dans lequel la première extrémité (110') de chaque élément thermoélectrique (110) est superposée, le long du premier axe (Z), sur la cavité (115) et la deuxième extrémité (110") de chaque élément thermoélectrique (110) est superposée, le long du premier axe (Z), sur le substrat (105),
le générateur thermoélectrique MEMS (10) comprenant en outre :
- une couche thermoplastique totale (20 ; 20, 48) s'étendant sur la couche électriquement isolante (120, 130) et ayant une surface supérieure (20a ; 52a) et une surface inférieure (20b) opposées l'une à l'autre le long du premier axe (Z), la surface inférieure (20b) de la couche électriquement isolante (120, 130) faisant face à la couche électriquement isolante (120, 130), la couche thermoplastique totale (20 ; 20, 48) étant faite d'un matériau thermiquement isolant et étant configurée pour être traitée par une technique de structuration directe au laser, ou LDS ;
- un dissipateur thermique (14) couplé à la cellule thermoélectrique et configuré pour échanger de la chaleur avec la cellule thermoélectrique (100) qui s'étend, le long du premier axe (Z), entre le dissipateur thermique (14) et la couche thermoplastique totale (20 ; 20, 48) ; et
- un trou d'interconnexion thermique (30 ; 30, 50) en matériau métallique, s'étendant à travers la couche thermoplastique totale (20 ; 20, 48) de la surface supérieure (20a ; 52a) à la surface inférieure (20b) de la couche thermoplastique totale (20 ; 20, 48) de telle manière qu'il est superposé, le long du premier axe (Z), sur la première extrémité (110') de chaque élément thermoélectrique (110),
dans lequel le générateur thermoélectrique MEMS (10) peut être couplé à une source thermique (12) de telle manière que la surface supérieure (20a ; 52a) de la couche thermoplastique totale (20 ; 20, 48) fait face à la source thermique (12) et la cellule thermoélectrique (100) échange de la chaleur, via le trou d'interconnexion thermique (30 ; 30, 50), avec la source thermique (12) pour générer la chute thermique entre les première (110') et deuxième (110") extrémités de chaque élément thermoélectrique (110).

2. Générateur thermoélectrique MEMS selon la revendication 1, dans lequel la couche thermoplastique totale (20 ; 20, 48) est faite d'un matériau polymère thermoplastique dopé avec des composés organométalliques configurés pour être activés chimiquement lorsqu'ils sont irradiés par un faisceau laser.

3. Générateur thermoélectrique MEMS selon la revendication 1 ou 2, dans lequel la cellule thermoélectrique (100) comprend une première pluralité desdits éléments thermoélectriques (110),
dans lequel la première pluralité d'éléments thermoélectriques (110) comprend une première pluralité respective de microstructures thermoélectriques (110N', 110P') qui sont interconnectées par l'intermédiaire d'éléments électriquement conducteurs (125) pour former un premier agencement en serpentin,
dans lequel la première pluralité de microstructures thermoélectriques (110N', 110P') comprend des microstructures thermoélectriques (110N' ; 110P') ayant un premier type de conductivité électrique et des microstructures thermoélectriques (110P' ; 110N') ayant un deuxième type de conductivité électrique, opposé au premier type, les microstructures thermoélectriques (110N' ; 110P') ayant le premier type de conductivité électrique et les microstructures thermoélectriques (110P' ; 110N') ayant le deuxième type de conductivité électrique étant alternées entre elles le long dudit premier agencement en serpentin, et
dans lequel les éléments thermoélectriques (110) et les éléments électriquement conducteurs (125) sont enfouis dans la couche électriquement isolante (120, 130).

4. Générateur thermoélectrique MEMS selon la revendication 3, dans lequel la cellule thermoélectrique (100) comprend en outre une deuxième pluralité desdits éléments thermoélectriques (110),
dans lequel la deuxième pluralité d'éléments thermoélectriques (110) comprend une deuxième pluralité respective de microstructures thermoélectriques (110N", 110P") qui sont interconnectées par l'intermédiaire d'éléments électriquement conducteurs respectifs (125) pour former un deuxième agencement en serpentin,
dans lequel la deuxième pluralité de microstructures thermoélectriques (110N", 110P") comprend des microstructures thermoélectriques respectives (110N" ; 110P") ayant le premier type de conductivité électrique et des microstructures thermoélectriques respectives (110P" ; 110N") ayant le deuxième type de conductivité électrique, les microstructures thermoélectriques (110N" ; 110P") ayant le premier type de conductivité électrique et les microstructures thermoélectriques (110P" ; 110N") ayant le deuxième type de conductivité électrique étant alternées entre elles le long dudit deuxième agencement en serpentin,
dans lequel la première pluralité de microstructures thermoélectriques (110N', 110P') est superposée, le long du premier axe (Z), sur la deuxième pluralité de microstructures thermoélectriques (110N", 110P"), et
dans lequel les microstructures thermoélectriques (110N', 110P') de la première pluralité et de la deuxième pluralité sont disposées électriquement les unes par rapport aux autres : en série, les premier et deuxième agencements en serpentin coïncidant ; ou en parallèle.

5. Générateur thermoélectrique MEMS selon la revendication 3 ou 4, dans lequel la cellule thermoélectrique (100) comprend en outre des bornes électriquement conductrices (132) placées aux extrémités du premier agencement en serpentin, en contact électrique avec les éléments thermoélectriques (110),
le générateur thermoélectrique MEMS comprenant en outre :
- pour chaque borne électriquement conductrice (132), un conducteur respectif (45) s'étendant, latéralement par rapport à la cellule thermoélectrique (100), sur le dissipateur thermique (14) de telle manière qu'il est isolé électriquement par rapport au dissipateur thermique (14) ou sur une carte à circuit imprimé (64) fixée au dissipateur thermique (14), la couche thermoplastique totale (20 ; 20, 48) s'étendant aussi sur les conducteurs (45) ; et
- pour chaque borne électriquement conductrice (132), une structure de connexion électrique respective (40) en matériau métallique, qui s'étend au moins partiellement dans la couche thermoplastique totale (20 ; 20, 48) et qui couple électriquement la borne électriquement conductrice respective (132) au conducteur (45) respectif.

6. Générateur thermoélectrique MEMS selon la revendication 5, dans lequel la couche thermoplastique totale (20) est formée par une première couche thermoplastique (20) comportant ladite surface supérieure (20a) et ladite surface inférieure (20b),
dans lequel le trou d'interconnexion thermique (30) est formé par un premier trou d'interconnexion thermique (30) ayant une première extrémité (30') et une deuxième extrémité (30") opposées l'une à l'autre le long du premier axe (Z), la première extrémité (30') du premier trou d'interconnexion thermique (30) faisant face à la surface supérieure (20a) de la première couche thermoplastique (20) et la deuxième extrémité (30") du premier trou d'interconnexion thermique (30) étant en contact avec la couche électriquement isolante (120, 130) de telle manière qu'elle est superposée, le long du premier axe (Z), sur la première extrémité (110') de chaque élément thermoélectrique (110),
dans lequel chaque structure de connexion électrique (40) comprend un premier trou d'interconnexion électrique (41), un deuxième trou d'interconnexion électrique (42) et une partie de connexion électrique (43) qui relie les premier (41) et deuxième (42) trous d'interconnexion électrique,
dans lequel le premier trou d'interconnexion électrique (41) s'étend, latéralement par rapport au premier trou d'interconnexion thermique (30), à travers la première couche thermoplastique (20), de la surface supérieure (20a) de la première couche thermoplastique (20) à la cellule thermoélectrique (100), de telle manière qu'il est en contact électrique avec la borne électriquement conductrice respective (132),
dans lequel le deuxième trou d'interconnexion électrique (42) s'étend, latéralement par rapport au premier trou d'interconnexion électrique (41), à travers la première couche thermoplastique (20), de la surface supérieure (20a) de la première couche thermoplastique (20) au conducteur respectif (45), de telle manière qu'il est en contact électrique avec le conducteur respectif (45),
dans lequel la partie de connexion électrique (43) s'étend sur la surface supérieure (20a) de la première couche thermoplastique (20) entre les premier (41) et deuxième (42) trous d'interconnexion électrique, de telle manière qu'ils sont en contact électrique l'un avec l'autre, et
dans lequel une couche isolante (44), en matériau isolant, s'étend sur la partie de connexion électrique (43).

7. Générateur thermoélectrique MEMS selon la revendication 5, dans lequel la couche thermoplastique totale (20, 48) est formée par une première couche thermoplastique (20) et par une deuxième couche thermoplastique (48) s'étendant sur la première couche thermoplastique (20) et formée d'un seul tenant avec la première couche thermoplastique (20), la première couche thermoplastique (20) définissant ladite surface inférieure (20b) de la couche thermoplastique totale (20, 48) et la deuxième couche thermoplastique (48) définissant ladite surface supérieure (52a), et
dans lequel le trou d'interconnexion thermique (30, 50) est formé par un premier trou d'interconnexion thermique (30) et par un deuxième trou d'interconnexion thermique (50) s'étendant sur le premier trou d'interconnexion thermique (30) et formé d'un seul tenant avec le premier trou d'interconnexion thermique (30), le premier trou d'interconnexion thermique (30) s'étendant à travers la première couche thermoplastique (20) et le deuxième trou d'interconnexion thermique (50) s'étendant à travers la deuxième couche thermoplastique (48), le trou d'interconnexion thermique (30, 50) ayant une première extrémité (50') et une deuxième extrémité (30") opposées l'une à l'autre le long du premier axe (Z), la première extrémité (50') du trou d'interconnexion thermique (30, 50) faisant partie du deuxième trou d'interconnexion thermique (50) et faisant face à la surface supérieure (52a) de la couche thermoplastique totale (20, 48) et la deuxième extrémité (30") du trou d'interconnexion thermique (30, 50) faisant partie du premier trou d'interconnexion thermique (30) et étant en contact avec la couche électriquement isolante (120, 130) de telle manière qu'elle est superposée, le long du premier axe (Z), sur la première extrémité (110') de chaque élément thermoélectrique (110),
dans lequel chaque structure de connexion électrique (40) comprend un premier trou d'interconnexion électrique (41), un deuxième trou d'interconnexion électrique (42) et un trou de connexion électrique (43) qui est intercalé, le long du premier axe (Z), entre les première (20) et deuxième (48) couches thermoplastiques et qui relie les premier (41) et deuxième (42) trous d'interconnexion électrique,
dans lequel le premier trou d'interconnexion électrique (41) s'étend, latéralement par rapport au premier trou d'interconnexion thermique (30), à travers la première couche thermoplastique (20), de la partie de connexion électrique (43) à la cellule thermoélectrique (100) de telle manière qu'il est en contact électrique avec la borne électriquement conductrice respective (132),
dans lequel le deuxième trou d'interconnexion électrique (42) s'étend, latéralement par rapport au premier trou d'interconnexion électrique (41), à travers la première couche thermoplastique (20), de la partie de connexion électrique (43) au conducteur respectif (45) de telle manière qu'il est en contact électrique avec le conducteur respectif (45), et
dans lequel la partie de connexion électrique (43) s'étend, le long du deuxième axe (X), entre les premier (41) et deuxième (42) trous d'interconnexion électrique de telle manière qu'ils sont en contact électrique l'un avec l'autre.

8. Générateur thermoélectrique MEMS selon la revendication 5, dans lequel chaque structure de connexion électrique (40) comprend un fil conducteur respectif (66) en matériau métallique, s'étendant dans la couche thermoplastique totale (20) et ayant une première extrémité (66a) et une deuxième extrémité (66b) opposées l'une à l'autre, la première extrémité (66a) du fil conducteur (66) étant fixée à la borne électriquement conductrice respective (132) et la deuxième extrémité (66b) du fil conducteur (66) étant fixée au conducteur respectif (45).

9. Générateur thermoélectrique MEMS selon l'une quelconque des revendications précédentes, dans lequel lesdits un ou plusieurs éléments thermoélectriques (110) sont faits de polysilicium ou de polysilicium-germanium.

10. Procédé de fabrication d'un générateur thermoélectrique MEMS (10) comprenant les étapes suivantes :
- former, sur une première surface (105a) d'un substrat (105) en matériau semiconducteur, une couche électriquement isolante (120, 130) en matériau électriquement isolant, le substrat (105) comportant aussi une deuxième surface (105b) opposée à la première surface (105a) le long d'un premier axe (Z), dans lequel un ou plusieurs éléments thermoélectriques (110) en matériau thermoélectrique s'étendent dans la couche électriquement isolante (120, 130), chaque élément thermoélectrique (110) ayant une première extrémité (110') et une deuxième extrémité (110") opposées l'une à l'autre le long d'un deuxième axe (X) orthogonal au premier axe (Z) et étant configuré pour convertir une chute thermique entre les première (110') et deuxième (110") extrémités en un potentiel électrique entre les première (110') et deuxième (110") extrémités par effet Seebeck ; et
- former, dans le substrat (105), une cavité (115) qui s'étend de la deuxième surface (105b) du substrat (105) à la première surface (105a) du substrat (105),
dans lequel la première extrémité (110') de chaque élément thermoélectrique (110) est superposée, le long du premier axe (Z), sur la cavité (115) et la deuxième extrémité (110") de chaque élément thermoélectrique (110) est superposée, le long du premier axe (Z), sur le substrat (105), et
dans lequel le substrat (105), la couche électriquement isolante (120, 130) et lesdits un ou plusieurs éléments thermoélectriques (110) définissent une cellule thermoélectrique (100) du générateur thermoélectrique MEMS (10),
le procédé de fabrication comprenant en outre les étapes suivantes :
- coupler la cellule thermoélectrique (100) à un dissipateur thermique (14) configuré pour échanger de la chaleur avec la cellule thermoélectrique (100), le dissipateur thermique (14) faisant face à la deuxième surface (105b) du substrat (105) ;
- former, sur la couche électriquement isolante (120, 130), une couche thermoplastique totale (20 ; 20, 48) ayant une surface supérieure (20a ; 52a) et une surface inférieure (20b) opposées l'une à l'autre le long du premier axe (Z), la surface inférieure (20b) de la couche électriquement isolante (120, 130) faisant face à la couche électriquement isolante (120, 130), la couche thermoplastique totale (20 ; 20, 48) étant faite d'un matériau thermiquement isolant et étant configurée pour être traitée par une technique de structuration directe au laser, ou LDS ; et
- former, dans la couche thermoplastique totale (20 ; 20, 48), un trou d'interconnexion thermique (30 ; 30, 50) en matériau métallique, qui s'étend de la surface supérieure (20a ; 52a) à la surface inférieure (20b) de la couche thermoplastique totale (20 ; 20, 48) de telle manière qu'il est superposé, le long du premier axe (Z), sur la première extrémité (110') de chaque élément thermoélectrique (110),
dans lequel le générateur thermoélectrique MEMS (10) peut être couplé à une source thermique (12) de telle manière que la surface supérieure (20a ; 52a) de la couche thermoplastique totale (20 ; 20, 48) fait face à la source thermique (12) et la cellule thermoélectrique (100) échange de la chaleur, via le trou d'interconnexion thermique (30 ; 30, 50), avec la source thermique (12) pour générer la chute thermique entre les première (110') et deuxième (110") extrémités de chaque élément thermoélectrique (110).

11. Procédé de fabrication selon la revendication 10, dans lequel l'étape de formation de la couche électriquement isolante (120, 130) comprend les opérations suivantes :
a. former, sur la première surface (105a) du substrat (105), une couche électriquement isolante inférieure (120) en matériau électriquement isolant ;
b. former, sur la couche électriquement isolante inférieure (120), une couche de matériau thermoélectrique (204) en matériau thermoélectrique ;
c. former, dans la couche de matériau thermoélectrique (204), au moins une première partie dopée (206N) en dopant au moins une première région exposée respective (204N) de la couche de matériau thermoélectrique (204) avec une espèce dopante ayant un premier type de conductivité électrique ;
d. retirer la couche de matériau thermoélectrique (204) en laissant ladite au moins une première partie dopée (206N) sur la couche électriquement isolante inférieure (120), chaque première partie dopée (206N) formant un élément thermoélectrique respectif (110N) avec le premier type de conductivité desdits éléments thermoélectriques (110) ;
e. former, sur la couche électriquement isolante inférieure (120) et sur chaque élément thermoélectrique (110), une première couche isolante (129) en matériau électriquement isolant qui est comprise dans une couche électriquement isolante supérieure (130), la couche électriquement isolante inférieure (120) et la couche électriquement isolante supérieure (130) définissant ladite couche électriquement isolante (120, 130).

12. Procédé de fabrication selon la revendication 11, dans lequel l'étape de formation de la couche électriquement isolante (120, 130) comprend en outre les opérations suivantes :
- entre l'étape c et l'étape d, former dans la couche de matériau thermoélectrique (204) au moins une deuxième partie dopée (206P) en dopant, avec d'autres espèces dopantes ayant un deuxième type de conductivité électrique opposé au premier type, au moins une deuxième région exposée (204P) de la couche de matériau thermoélectrique (204), latérale par rapport à ladite au moins une première région exposée (204N) ;
- pendant l'étape d, retirer la couche de matériau thermoélectrique (204) en laissant ladite au moins une première partie dopée (206N) et ladite au moins une deuxième partie dopée (206P) sur la couche électriquement isolante inférieure (120), chaque deuxième partie dopée (206P) formant un élément thermoélectrique respectif (110P) avec le deuxième type de conductivité desdits éléments thermoélectriques (110) ;
- après l'étape e, former, à travers la première couche isolante (129), au moins un élément électriquement conducteur (125) en matériau conducteur, qui réalise un contact électrique avec un élément thermoélectrique respectif (110N) ayant le premier type de conductivité et un élément thermoélectrique respectif (110P) ayant le deuxième type de conductivité pour les interconnecter ; et
- former, sur la première couche isolante (129) et sur ledit au moins un élément électriquement conducteur (125), une ou plusieurs deuxièmes couches isolantes en matériau électriquement isolant qui définissent, avec la première couche isolante (129), ladite couche électriquement isolante supérieure (130).

13. Procédé de fabrication selon l'une quelconque des revendications 10 à 12, dans lequel l'étape de formation de la cavité (115) dans le substrat (105) comprend les opérations suivantes :
- coupler temporairement la cellule thermoélectrique (100) à une plaquette de transport (216), la plaquette de transport (216) faisant face à la couche électriquement isolante (120, 130) de la cellule thermoélectrique (100) ;
- réaliser une gravure au niveau d'une région de cavité (220) de la deuxième surface (105b) du substrat (105) pour former la cavité (115), la région de cavité (220) étant alignée le long du premier axe (Z) avec la première extrémité (110') de chaque élément thermoélectrique (110) ; et
- découpler la cellule thermoélectrique (100) et la plaquette de transport (216) l'une de l'autre.

14. Procédé de fabrication selon l'une quelconque des revendications 10 à 13, dans lequel l'étape de formation d'une couche thermoplastique totale (20 ; 20, 48) comprend le fait de former une première couche thermoplastique (20) sur la couche électriquement isolante (120, 130) par moulage par injection, la première couche thermoplastique (20) définissant la couche thermoplastique totale (20) ou étant comprise dans la couche thermoplastique totale (20, 48).

15. Procédé de fabrication selon la revendication 14, dans lequel l'étape de formation du trou d'interconnexion thermique (30 ; 30, 50) dans la couche thermoplastique totale (20 ; 20, 48) comprend les opérations suivantes :
- former une première tranchée (140) dans la première couche thermoplastique (20), d'une surface supérieure (20a) à une surface inférieure (20b) de la première couche thermoplastique (20), la première tranchée (140) étant formée en irradiant au laser avec une technique LDS une première région de tranchée de la surface supérieure (20a) de la première couche thermoplastique (20) pour retirer sélectivement une partie correspondante de la première couche thermoplastique (20), la première région de tranchée étant superposée, le long du premier axe (Z), sur la cavité (115) ; et
- réaliser un dépôt de métal dans la première tranchée (140) pour former un premier trou d'interconnexion thermique (30), le premier trou d'interconnexion thermique (30) étant le trou d'interconnexion thermique (30) ou étant une partie du trou d'interconnexion thermique (30, 50).

16. Procédé de fabrication selon la revendication 15, dans lequel la cellule thermoélectrique (100) comprend une pluralité desdits éléments thermoélectriques (110) interconnectés pour former un agencement en serpentin,
le procédé de fabrication comprenant en outre les étapes suivantes :
- former, dans la couche électriquement isolante (120, 130), des bornes électriquement conductrices (132) placées aux extrémités de l'agencement en serpentin et exposées par la couche électriquement isolante (120, 130) ;
- pour chaque borne électriquement conductrice (132), former une deuxième tranchée respective (141) et une troisième tranchée respective (142) dans la première couche thermoplastique (20), de la surface supérieure (20a) à la surface inférieure (20b) de la première couche thermoplastique (20), les deuxième (141) et troisième (142) tranchées respectives étant agencées latéralement par rapport à la première tranchée (140) et étant formées en irradiant au laser avec une technique LDS des deuxième et troisième régions de tranchée respectives de la surface supérieure (20a) de la première couche thermoplastique (20) pour retirer sélectivement des parties correspondantes de la première couche thermoplastique (20), les deuxième et troisième régions de tranchée respectives étant superposées, le long du premier axe (Z), sur la borne électriquement conductrice respective (132) et, respectivement, sur un conducteur respectif (45) s'étendant sur le dissipateur thermique (14) latéralement à la cellule thermoélectrique (100), la première couche thermoplastique (20) étant aussi formée sur le conducteur respectif (45) ;
- pour chaque borne électriquement conductrice (132), activer chimiquement, par irradiation laser avec une technique LDS, une région activée respective (143) de la surface supérieure (20a) de la première couche thermoplastique (20), qui s'étend entre les deuxième et troisième régions de tranchée respectives ; et
- réaliser un dépôt de métal dans les deuxième (141) et troisième (142) tranchées pour former des premier (41) et deuxième (42) trous d'interconnexion électrique respectifs, et sur les régions activées (143) pour former des parties de connexion électrique respectives (43) intercalées le long du deuxième axe (X) entre les premier (41) et deuxième (42) trous d'interconnexion électrique respectifs, les premier (41) et deuxième (42) trous d'interconnexion électrique respectifs et les parties de connexion électrique respectives (43) formant ensemble des structures de connexion électrique respectives (40) qui connectent électriquement les bornes électriquement conductrices respectives (132) et les conducteurs respectifs (45) les uns aux autres.

17. Procédé de fabrication selon la revendication 16, comprenant en outre l'étape consistant à former une couche isolante (44) en matériau isolant sur chacune des structures de connexion électrique (40), ou
comprenant en outre les étapes suivantes :
- former par moulage par injection une deuxième couche thermoplastique (48) sur la première couche thermoplastique (20), sur les structures de connexion électrique (40) et sur le premier trou d'interconnexion thermique (30), la deuxième couche thermoplastique (48) formant avec la première couche thermoplastique (20) ladite couche thermoplastique totale (20, 48) ; et
- former, dans la deuxième couche thermoplastique (48), un deuxième trou d'interconnexion thermique (50) en matériau métallique, superposé, le long du premier axe (Z), sur le premier trou d'interconnexion thermique (50), les premier (30) et deuxième (50) trous d'interconnexion thermique formant ledit trou d'interconnexion thermique (30, 50).

18. Procédé de fabrication selon l'une quelconque des revendications 10 à 15, dans lequel la cellule thermoélectrique (100) comprend une pluralité desdits éléments thermoélectriques (110) interconnectés pour former un agencement en serpentin,
le procédé de fabrication comprenant en outre, avant la formation de la couche thermoplastique totale (20) sur la couche électriquement isolante (120, 130), les étapes suivantes :
- former, dans la couche électriquement isolante (120, 130), des bornes électriquement conductrices (132) placées aux extrémités de l'agencement en serpentin et exposées par la couche électriquement isolante (120, 130) ;
- fixer sur chaque borne électriquement conductrice (132) une première extrémité (66a) d'un fil conducteur respectif (66), et sur un conducteur respectif (45), une deuxième extrémité (66a) dudit fil conducteur respectif (66), les première (66a) et deuxième (66b) extrémités de chaque fil conducteur (66) étant opposées l'une à l'autre, ledit conducteur (45) s'étendant sur le dissipateur thermique (14) latéralement par rapport à la cellule thermoélectrique (100) ; et
- former la couche thermoplastique totale (20) aussi sur les fils conducteurs (66).

19. Système chauffant (500) comprenant un appareil chauffant (502) et un appareil de commande (504) comportant un générateur thermoélectrique MEMS (10) selon l'une quelconque des revendications 1 à 9, couplé à l'appareil chauffant (502) pour échanger de la chaleur avec l'appareil chauffant (502), l'appareil chauffant (502) étant ladite source thermique (12).
